# EUROPEAN PATENT APPLICATION

(11) **EP 1 376 241 A1**
(43) Date of publication of application: **02.01.2004**
(21) Application number: 03014157.6
(22) Date of filing: 24.06.2003
(51) Int. Cl.: G03F 7/32, B41C 1/10

(54) **Method for preparing lithographic printing plate**

(30) Priority: 24.06.2002 JP 2002182925
(71) Applicant: Fuji Photo Film Co., Ltd., Kanagawa (JP)
(72) Inventor: Nagase, Hiroyuki, Yoshida-cho, Haibara-gun, Shizuoka (JP)
(74) Representative: Grünecker, Kinkeldey, Stockmair & Schwanhäusser Anwaltssozietät

(57) **Abstract**

A method for preparing a lithographic printing plate is provided which can well disperse insoluble matter caused by components of an image-forming layer in a plate-making process to inhibit the generation of processing scum, while maintaining good developing properties, and can further provide the plate having no gum repellency thereon and improved in the state of a gum-coated surface, the method for preparing a lithographic printing plate comprising exposing a photosensitive lithographic printing plate precursor having an image-forming layer containing an infrared absorption dye, and developing the exposed photosensitive lithographic printing plate precursor with an alkali developer containing a sulfonate group-containing anionic surfactant.

## Description

### FIELD OF THE INVENTION

The present invention relates to a method for preparing a lithographic printing plate from a so-called direct digital lithographic printing plate precursor which can be directly produced by infrared laser scanning based on a digital signal of a computer or the like, using a specific alkali developer.

### BACKGROUND OF THE INVENTION

The recent development of lasers is remarkable. In particular, as for solid lasers and semiconductor lasers having a light-emitting region ranging from infrared to far infrared, high-output and small-sized ones have become easily available, and these lasers are very useful as exposure light sources used in a system of directly making plates from digital data.

As an image recordingmaterial suitable for laser writing, JP-A-7-285275 (the term "JP-A" as used herein means an "unexamined published Japanese patent application") proposes, for example, a positive image recording material containing a binder such as a cresol resin, a substance absorbing light to generate heat, and a compound which is thermally decomposable and can substantially reduce the solubility of the binder in a state before decomposition, such as quinonediazide.

In this image recording material, the substance absorbing light to generate heat generates heat in an exposed area by infrared irradiation to make the recorded area alkali soluble (a heat mode type) . However, the heat is absorbed by aluminum of a support to cause low heat efficiency, resulting in insufficient solubility of the exposed area to an alkali developer in a developing process. For this reason, the alkali concentration of the developing solution has been increased to secure the solubility of the exposed area.

However, a heat mode type lithographic printing precursor is low in dissolution resistance of the image area to the alkali developer under such concentrated alkali conditions as described above, and has the problem that the presence of slight scratches on a surface of the image recording material causes the image area to be dissolved, thereby generating defects on the image area. In particular, in a positive lithographic printing precursor using a polymer compound high in solubility to an aqueous alkali solution, this tendency has been significant.

Accordingly, there is a limit to increasing the alkali concentration of the developing solution so that a residual film is not produced on a non-image area.

Further, with the recent development of infrared laser exposure type image recording materials, infrared absorption dyes difficult to be dissolved in the alkali developers, compared to the conventional infrared absorption dyes, for example, cyanine dyes, tend to be used. When this image recording material is developed with the alkali developer, insoluble matter of the infrared absorption dye tends to be formed in the developing solution. This further forms insoluble matter by interaction with a component of a binder polymer and inorganic matter in water, resulting in the accumulation and coagulation sedimentation of the insoluble matter to generate processing scum during continuation of processing, which constitutes a factor making the processing unstable.

Specifically, the insoluble matter causes the disadvantage that the insoluble matter adheres onto a plate to impair an image, or that the insoluble matter is precipitated or separated in a processing bath to cause a burden in maintenance of the processing bath. For example, when burning treatment is conducted, as the processing scum adheres onto a non-image area under such conditions, there is also the disadvantage that the adhered matter is carbonize to bring about stains in printing.

Further, in the infrared laser exposure type image recording material, a fluorine compound is used in a photosensitive material in some cases, so that gum repellency is liable to occur on a plate. Accordingly, the problem is encountered that a portion at which gum on the plate is repelled leads to a print stain and a portion relatively thickly coated with the gum contributes to poor ink adhesion.

It has been therefore required to provide a plate avoiding the disadvantage due to the processing scum as described above and having no problem of the gum repellency, and to form a highly sharp and clear image without giving a defect to an image area. In particular, it has been required to increase sharpness and to improve reproducibility in a fine image containing a dot portion or a thin line.

### SUMMARY OF THE INVENTION

An object of the invention is to provide a method for preparing a lithographic printing plate by which the generation of processing scum is inhibited in a plate making process, the processing scum is prevented from adhering to a plate or being precipitated or separated in a processing bath, development can be carried out stably for a long period of time, the plate having no gum repellency thereon can be prepared, and a highly sharp and clear image can be obtained.

In order to attain the above-mentioned object, the present inventors have conducted intensive investigation. As a result, the inventors have discovered that addition of a anionic surfactant containing a sulfonate group (a sulfonate group-containing anionic surfactant) to a developing solution allows the generation of processing scum to be inhibited in processing, while maintaining liquid conditions suitable for a developing solution, and solves the problem of gum repellency on a plate to be able to provide the plate improved in the state of a gum-coated surface. Thus, the inventors have completed the invention. In particular, the inventors have discovered that an anionic surfactant containing a specific sulfonate has the characteristics that the surfactant is excellent in dispersibility of processing scum component and easily soluble in the developing solution having a high alkali concentration, and has less problem with regard to turbidity of the solution.

That is to say, the invention is as follows:
(1) A method for preparing a photosensitive lithographic printing plate precursor, comprising:
   exposing a photosensitive lithographic printing plate precursor having an image-forming layer containing an infrared absorption dye; and
   developing the exposed photosensitive lithographic printing plate precursor with an alkali developer, in which the alkali developer includes an anionic surfactant containing a sulfonate group.
(2) The method according to the item (1), wherein the anionic surfactant is an anionic surfactant represented by the formula: 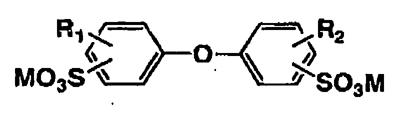 wherein R₁ and R₂ are each independently represents a hydrogen atom or an alkyl group which may be branched, and M represents a univalent alkali metal.
(3) The method according to the item (1), wherein the alkali developer comprises: at least one of an alkali silicate and a nonreducing sugar; and a base.
(4) The method according to the item (1), wherein the alkali developer has a pH of 12.5 to 14.0.
(5) The method according to the item (1), wherein the alkali developer contains silicone oxide and an alkali oxide: M₂O, in which M represents an alkali metal or an ammonium group.
(6) The method according to the item (5), wherein the mixing ratio of the silicon oxide to the alkali oxide: M₂O is 0.5 to 3.0.
(7) The method according to the item (1), wherein the infrared absorption dye includes at least one of a cyanine dye, a squalilium dye, a pyrylium salt and a nickel thiolate complex.
(8) The method according to the item (1), wherein the infrared absorption dye includes a compound represented by the formula (Z) 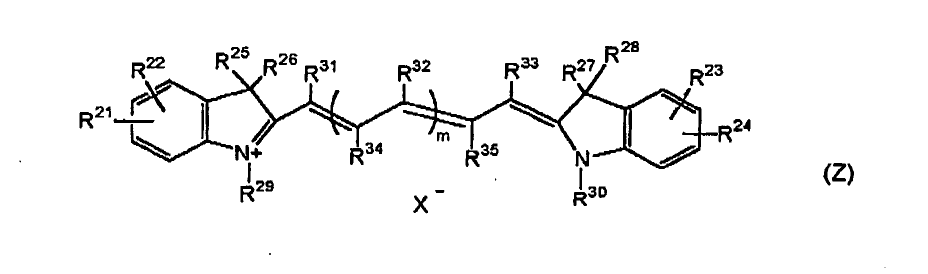 wherein R²¹ to R²⁴ each independently represents a hydrogen atom, or an alkyl group having 1 to 12 carbon atoms, an alkenyl group, an alkoxyl group, a cycloalkyl group or an aryl group, each of which may have a substituent group, and R²¹ and R²², and R²³ and R²⁴ may combine with each other to form a ring structure; R²⁵ to R³⁰ each independently represents an alkyl group having 1 to 12 carbon atoms which may have a substituent group; R³¹ to R³³ each independently represents a hydrogen atom, a halogen atom or an alkyl group having 1 to 8 carbon atoms which may have a substituent group, R³² may combine with R³¹ or R³³ to form a ring structure, and, when m is more than 2, a plurality of R³²'s may combine with each other to form a ring structure; m represents an integer of from 1 to 8; R³⁴ and R³⁵ each independently represents a hydrogen atom, a halogen atom or an alkyl group having 1 to 8 carbon atoms which may have a substituent group, R³⁴ may combine with R³⁵ to form a ring structure, and, when m is more than 2, a plurality of R³⁴'s may combine with each other to form a ring structure; X⁻ represents an anion.
(9) The method according to the item (1), wherein the image-forming layer contains the infrared absorption dye in an amount of 0.01 to 50 % by weight based on the total solid weight of the image-forming layer.

### DETAILED DESCRIPTION OF THE INVENTION

First, the alkali developer used in the platemakingmethod of the invention will be described.

The alkali developer used in processing (hereinafter also briefly referred to as the developing solution) is an alkaline aqueous solution, and can be appropriately selected from conventional aqueous alkali solutions.

The aqueous alkali solutions include a developing solution comprising an alkali silicate or a nonreducing sugar and a base, and particularly preferred is a developing solution having a pH of 12.5 to 14.0.

The alkali silicate is a compound showing alkalinity when dissolved in water, and examples thereof include alkali metal silicates such as sodium silicate, potassium silicate and lithium silicate, and ammonium silicate.

The alkali silicates may be used either alone or as a combination of two or more of them.

The developing properties of the aqueous alkali solution can be easily controlled by adjusting the mixing ratio of silicone oxide: SiO₂ as a silicate component, to an alkali oxide M₂O (M represents an alkali metal or an ammonium group) and the concentration.

Of the above-mentioned alkali solutions, preferred is one having a mixing ratio of silicon oxide SiO₂ to an alkali oxide M₂O (SiO₂/M₂O molar ratio) of 0.5 to 3.0, and more preferred is one having a mixing ratio of 0.75 to 1.5.

When the SiO₂/M₂O ratio is less than 0.5, the adverse effect that an aluminum plate generally used as a support of a lithographic printing plate precursor is etched is exerted in some cases, because the alkali strength becomes strong. On the other hand, exceeding 3.0 sometimes results in deterioration of developing properties.

Further, the concentration of the alkali silicate in the developing solution is preferably from 1% to 10% by weight, more preferably from 3% to 8% by weight, and most preferably from 4% to 7% by weight, based on the weight of the aqueous alkali solution. When the concentration is less than 1% by weight, developing properties and processing ability are reduced in some cases. On the other hand, when the concentration exceeds 10% by weight, a precipitate or crystals are liable to be formed, and further, gelation is liable to occur in neutralizing waste fluid, which sometimes causes a disadvantage for waste fluid processing.

In the developing solution comprising the nonreducing sugar and the base, the nonreducing sugar means a saccharide having no reducibility because it has no free aldehyde or ketone group. The nonreducing sugars are classified into three types, a trehalose type oligosaccharide in which reducing groups are bonded to each other, a glycoside in which a reducing group of a saccharide is bonded to a non-saccharide, and a sugar alcohol obtained by reduction of a saccharide by hydrogenation. In the invention, any one of these can be suitably used.

The trehalose type oligosaccharides include, for example, saccharose and trehalose, and the glycosides include, for example, an alkyl glycoside, a phenol glycoside and a mustard oil glycoside.

The sugar alcohols include, for example, D-, L-arabit, ribit, xylit, D-, L-sorbit, D-, L-mannit, D-, L-idit, D-, L-tarit, zrisit and arozrusit. Further, preferred examples thereof include a multitol obtained by hydrogenation of a disaccharide and a reduced product (reduced starch syrup) obtained by hydrogenation of an oligosaccharide.

Of the above, the sugar alcohols and saccharose are preferred as the nonreducing sugars, and D-sorbit, saccharose and reduced starch syrup are more preferred among others in that they have a buffering action in a moderate pH region.

These nonreducing sugars may be used either alone or as a combination of two or more of them. The proportion occupied by the nonreducing sugar in the developing solution is preferably from 0.1% to 30% by weight, and more preferably from 1% to 20% by weight.

An alkali agent can be appropriately selected as the base from known agents, and combined with the above-mentioned alkali silicate or nonreducing sugar.

The alkali agents include, for example, inorganic alkali agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate, potassium citrate, tripotassium citrate and sodium citrate.

Preferred examples of the alkali agents further include organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkali agents may be used either alone or as a combination of two or more of them.

Sodium hydroxide and potassium hydroxide are preferred among others. The reason for this is that pH adjustment becomes possible in a wide pH region by adjusting the amount thereof added to the nonreducing sugar. Further, trisodium phosphate, tripotassium phosphate, sodium carbonate and potassium carbonate are also preferred because they themselves have a buffering action.

In the developing agent used in the invention, it is indispensable that the aqueous alkali solution as described above contains a sulfonate group-containing anionic surfactant.

Preferred examples of the anionic surfactants include a hydroxyalkanesulfonate, an alkanesulfonate, an alkyldiphenylethersulfonate, a diphenyletherdisulfonate represented by the following general formula, a dialkylsulfosuccinic acid ester salt, an olefinsulfonate, a straight-chain alkylbenzenesulfonate, a branched alkylbenzenesulfonate, an alkylnaphthalenesulfonate, an alkylphenoxypolyoxyethylenepropylsulfonate, apolyoxyethylene alkylsulfophenyl ether salt, a N-alkylsulfosuccinmonoamide disodium salt and a petroleum sulfonate. 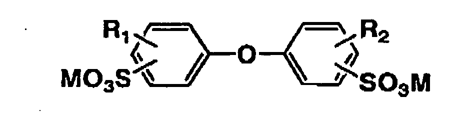 wherein R₁ and R₂ each independently represents a hydrogen atom or an alkyl group which may be branched, and M represents a univalent alkali metal.

The alkyl group is preferably an alkyl group having 1 to 40 carbon atoms, particularly 4 to 20 carbon atoms. Specific examples thereof include nC₈H₁₇ and nC₁₂H_{25.} Although the alkali metal may be any, sodium, potassium and lithium are preferred among others.

Particularly preferred examples of these compounds include compounds having the following structures. These may be used either alone or as a combination of two or more of them. Of these, in view of preventing the processing scum from adhering in a rundown state of developer, a compound having two sulfonate groups in the molecule is preferable, the following compounds (A-1) to (A-4) are more preferable: 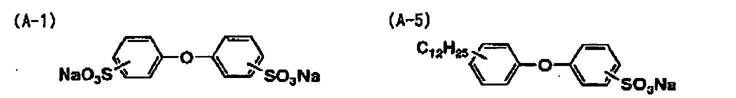 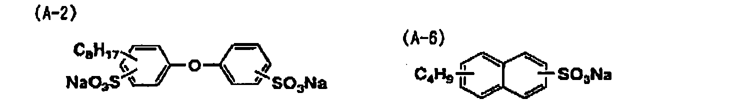 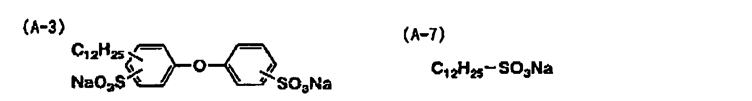 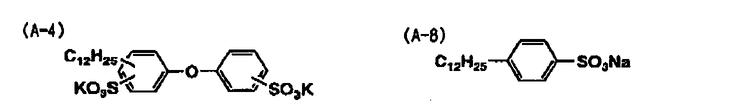 In the present invention, the alkali developer preferably contains the anionic surfactant containing a sulfonate group in a concentration of 0.01 to 10 g/L, more preferably 0.05 to 3 g/L.

In order to further enhance the development performance, additives as described below can be added to the alkali developer.

The additives include, for example, neutral salts such as NaCl, KCl and KBr described in JP-A-58-75152, chelating agents such as EDTA and NTA described in JP-A-58-190952, complexes such as [Co (NH₃) ₆] Cl₃ and CoCl₂·6H₂O described in JP-A-59-121336, nonionic surfactants such as tetramethyldecynediol described in U.S. Patent 4,374,920, cationic polymers such as a methyl chloride quaternary compound of p-dimethylaminomethylpolystyrene described in JP-A-55-95946, amphoteric polymer electrolytes such as a copolymer of vinylbenzyltrimethylammonium chloride and sodium acrylate, reducing inorganic salts such as sodium sulfite described in JP-A-57-192951, inorganic lithium compounds such as lithium chloride described in JP-A-58-59444, organic metal surfactants such as an organic Si surfactant and an organic Ti surfactant described in JP-A-59-75255, organic boron compounds described in JP-A-59-84241 and quaternary ammonium salts such as a tetraalkylammonium oxide described in EP 101010.

Further, the surface tension of the developing solution is preferably 65 dynes/cm or less, and more preferably 60 dynes/cm or less. The surface tension of the developing solution can be measured, for example, by the vibration jet method. As a measuring instrument, there is an automatic dynamic surface tension meter (JET type).

There is no particular limitation on the use mode of the alkali developer in the invention.

In recent years, automatic processors for printing plate materials have been widely used for rationalization and standardization of plate making operations, particularly in the plate making-printing industry.

The automatic processor generally comprises a developing unit and an after-treatment unit, and further comprises an apparatus for conveying a printing plate material, respective processing solution tanks and spray devices. Respective processing solutions pumped up are sprayed from the spraynozzles on a printing plate exposed while horizontally conveying the printing plate. Recently, a method of conveying a printing plate material while immersing it in a processing solution tank filled with a processing solution with a guide roll mounted in the solution to conduct processing has also been known. In such automatic processing, the printing plate material can be processed while replenishing replenishers to the respective processing solutions depending on the processed amount and the operating time.

In this case, an aqueous solution having higher alkali strength than the developing solution is added to the developing solution as the replenisher, thereby being able to process a large amount of image-forming materials for a long period of time without the exchange of the developing solution in the tank. Also in using the alkali developer of the invention, it is a preferred embodiment to employ this replenishing system. As the replenisher used in this case, there can be used an aqueous solution obtained by making higher the alkali strength of the alkali developer described above.

In order to enhance and inhibit the development performance, and increase dispersion of the processing scum and ink affinity of the image area of the printing plate, various surfactants other than the above and organic solvents can also be added to the developing solution and the replenisher for the developing solution as needed.

As the organic solvent, benzyl alcohol is preferred. Further, polyethylene glycol or a derivative thereof, or polypropylene glycol or a derivative thereof is also preferably added.

It is also possible to add hydroquinone, resorcin, an inorganic salt-based reducing agent such as a sodium or potassium salt of sulfurous acid or hydrogensulfurous acid, an organic carboxylic acid, a defoaming agent or a water softener as needed.

The plate making method of the invention is also applicable to development of a so-called disposable processing system in which processing is conducted with a substantially virgin developing solution, as well as the above-mentioned development system.

The lithographic printing plate developed using the above-mentioned alkali developer is after treated with a rinse solution containing washing water and a surfactant, and with a desensitizing solution (gum solution) containing gum arabic and a starch derivative. This after treatment can be conducted in various combinations of these known processing solutions.

The lithographic printing plate precursor applicable to the plate making method of the invention will be described below.

An infrared photosensitive lithographic printing plate precursor comprises a support having provided thereon an image-forming layer and another layer as needed. The image-forming layer comprises (A) an infrared absorption dye, (B1) a carboxyl group-containing alkali-soluble polymer compound, (B2) an alkali-soluble resin, (C) a compound which is allowed to be compatible with the alkali-soluble polymer compound of (B1) and the alkali-soluble resin of (B2) to decrease the solubility of the alkali-soluble polymer compound and the alkali-soluble resin, and which decreases the solubility-decreasing action by heating, and (D) a cyclic acid anhydride. In the case of a negative lithographic printing plate precursor, the image-forming layer further comprises (E) a compound generating an acid by heat and (F) a crosslinking agent crosslinking with an acid.

Respective constituents will be briefly described below.

### (A) Infrared Absorption Dyes

There is no particular limitation on the infrared absorption dye used in the image-forming layer, as long as it is a dye which absorbs infrared light and generates heat. Various dyes known as the infrared absorption dyes can be used.

The infrared absorption dyes include commercially available dyes and known dyes described in documents (for example, "Senryo Binran (Dye Handbook)" (edited by Yuki Gosei Kagaku Kyokai (Organic Synthetic Chemical Society) , 1970), for example, an azo dye, a metal complex azo dye, a pyrazolone azo dye, a naphthoquinone dye, an anthraquinone dye, a phthalocyanine dye, a carbonium dye, a quinoneimine dye, a methine dye, cyanine dye, a squalilium dye, a pyrylium salt and a metal thiolato complex. Of these dyes, dyes absorbing infrared light or near-infrared light are particularly preferred in that they are suitable for utilization of lasers emitting infrared light or near-infrared light.

Preferred examples of such dyes absorbing infrared light or near-infrared light include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58--224793, JP-A-59-48187, JP-A-59-73996, JP-A-60-52940 and JP-A-60-63744, squalilium dyes described in JP-A-58-112792, cyanine dyes described in British Patent 434,875 and dihydroperimidinesqualilium dyes described in U.S. Patent 5,380,635.

Further, a near-infrared absorption sensitizer described in U.S. Patent 5,156,938 is also preferred as the dye. Arylbenzo(thio)pyrylium salts described in U.S. Patent 3,881,924, trimethinethiapyrylium salts described in JP-A-57-142645 (U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59--146061, cyanine dyes described in JP-A-59-216146, pentamethinethiopyrylium salts described in U.S. Patent 4,283,475, pyrylium compounds described in JP-B-5-13514 (the term "JP-B" as used herein means an "examined Japanese patent publication") and JP-B-5-19702, and commercially available Epolight III-178, Epolight III-130, Epolight 111-125 and Epolight IV-62A (manufactured by Epolin Inc.) are also preferred.

Furthermore, near-infrared absorption dyes represented by formulas (I) and (II) described in U.S. Patent 4,756,99, are also preferred.

Of the above, the cyanine dye, the squalilium dye, the pyrylium salt and the nickel thiolate complex are more preferred.

More particularly, the dyes include a compound represented by the following general formula (Z): 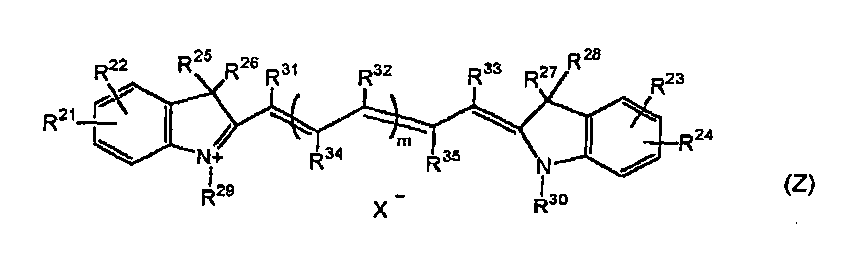 wherein R²¹ to R²⁴ each independently represents a hydrogen atom, or an alkyl group having 1 to 12 carbon atoms, an alkenyl group, an alkoxyl group, a cycloalkyl group or an aryl group, each of which may have a substituent group, and R²¹ and R²², and R²³ and R²⁴ may combine with each other to form a ring structure.

R²¹ to R²⁴ include, for example, a hydrogen atom, a methyl group, an ethyl group, aphenyl group, a dodecyl group, a naphthyl group, a vinyl group, an allyl group and a cyclohexyl group, and these groups may each further have a substituent group. The substituent groups used herein include, for example, a halogen atom, a carbonyl group, a nitro group, a nitrile group, a sulfonyl group, a carboxyl group, a carboxylate and a sulfonate.

In the formula, R²⁵ to R³⁰ each independently represents an alkyl group having 1 to 12 carbon atoms which may have a substituent group. R²⁵ to R³⁰ include, for example, a methyl group, an ethyl group, a phenyl group, a dodecyl group, a naphthyl group, a vinyl group, an allyl group and a cyclohexyl group, and these groups may each further have a substituent group. The substituent groups used herein include, for example, a halogen atom, a carbonyl group, a nitro group, a nitrile group, a sulfonyl group, a carboxyl group, a carboxylate and a sulfonate.

In the formula, R³¹ to R³³ each independently represents a hydrogen atom, a halogen atom or an alkyl group having 1 to 8 carbon atoms which may have a substituent group. R³² may combine with R³¹ or R³³ to form a ring structure, and in the case of m>2, a plurality of R³²'s may combine with each other to form a ring structure.

R³¹ to R³³ include, for example, a chlorine atom, a cyclohexyl group, and a cyclopentyl ring or a cyclohexyl ring formed by combination of R³²' s, and these groups may each further have a substituent group. The substituent groups used herein include, for example, a halogen atom, a carbonyl group, a nitro group, a nitrile group, a sulfonyl group, a carboxyl group, a carboxylate and a sulfonate.

Further, m represents an integer of from 1 to 8, preferably an integer of from 1 to 3.

In the formula, R³¹ and R³⁵ each independently represents a hydrogen atom, a halogen atom or an alkyl group having 1 to 8 carbon atoms which may have a substituent group. R³⁴ may combine with R³⁵ to form a ring structure, and in the case of m>2, a plurality of R³⁴' s may combine with each other to form a ring structure.

R³⁴ and R³⁵ include, for example, a chlorine atom, a cyclohexyl group, and a cyclopentyl ring or a cyclohexyl ring formed by combination of R³⁴' s, and these groups may each further have a substituent group. The substituent groups used herein include, for example, a halogen atom, a carbonyl group, a nitro group, a nitrile group, a sulfonyl group, a carboxyl group, a carboxylate and a sulfonate.

Further, m represents an integer of from 1 to 8, preferably an integer of from 1 to 3.

In the formula, X⁻ represents an anion, and examples thereof include perchloric acid, tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoylbenzenesulfonic acid and p-toluenesulfonic acid.

Above all, alkyl aromatic sulfonic acids such as hexafluorophosphoric acid, triisopropylnaphthalenesulfonic acid and 2,5-dimethylbenzenesulfonic acid are preferred.

Of the compounds represented by the above-mentioned general formula (Z), specifically, compounds shown below are suitably used. However, it is to be understood that the compounds are not limited thereto.

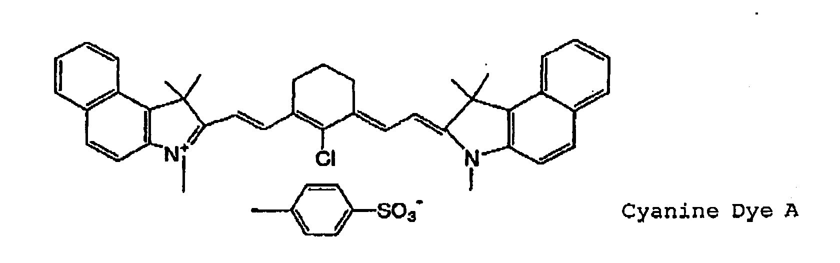

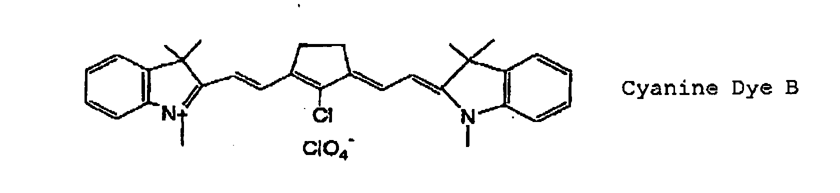

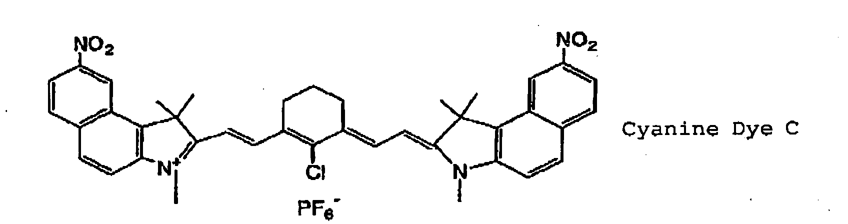

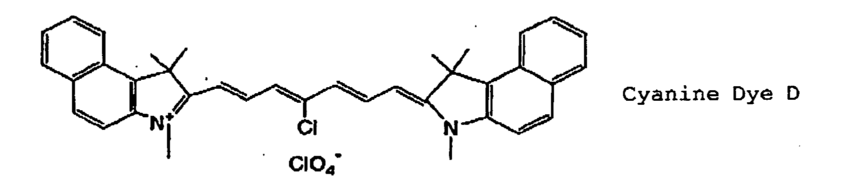

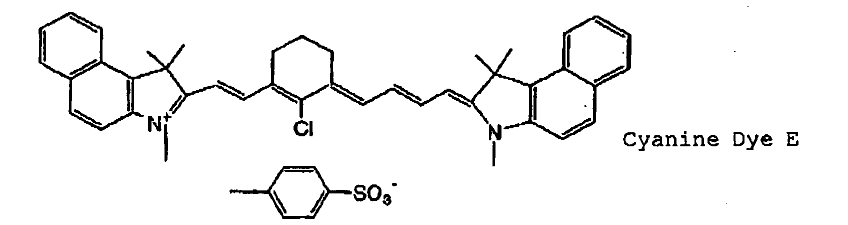

The content of the infrared absorption dye as described above is preferably from 0.01% to 50% by weight, more preferably from 0.1% to 10% by weight, and most preferably from 0.5% to 10% by weight, based on the total solid weight of the image-forming layer.

When the content is less than 0.01% by weight, the sensitivity is sometimes lowered. On the other hand, exceeding 50% by weight results in deterioration of the uniformity of the image-forming layer, which causes decreased durability in some cases.

### (B1) Carboxyl Group-Containing Alkali-Soluble Polymer Compounds (hereinafter also referred to as component (B1)

The polymer compound of component (B1) may be any, as long as it is a carboxyl group-containing alkali-soluble polymer compound. However, polymer compounds (b1-1) and (b1-2) defined by the following are preferred.

### (b1-1) Alkali-soluble polymer compounds having polymerizable monomer units represented by the following general formula (1) (hereinafter also referred to as polymer compound (b1-1))

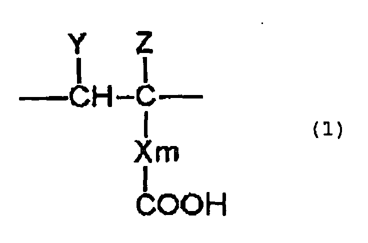

wherein Xm represents a single bond or a divalent connecting group, Y represents a hydrogen atom or a carboxyl group, and Z represents a hydrogen atom, an alkyl group or a carboxyl group.

Monomers constituting polymerizable monomer units represented by general formula (1) include a polymerizable monomer having at least one carboxyl group and at least one polymerizable unsaturated group in its molecule.

Specific examples of such polymerizable monomers include α- and β-unsaturated carboxylic acids such as acrylic acid, methacrylic acid, maleic acid, maleic anhydride, itaconic acid and itaconic anhydride.

Examples of monomers copolymerized with the above-mentioned carboxyl group-containing polymerizable monomers include but are not limited to the following (1) to (11):
(1) Aliphatic hydroxyl group-containing acrylates and methacrylates such as 2-hydroxyethyl acrylate and 2-hydroxyethyl methacrylate;
(2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylateandN-dimethylaminoethyl acrylate;
(3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate and N-dimethylaminoethyl methacrylate;
(4) Acrylamides and methacrylamides such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide;
(5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(6) Vinyl esters such as vinyl acetate, vinyl chloroacetate, vinyl butyrate and vinyl benzoate;
(7) Styrenes such as styrene, α-methylstyrene, methylstyrene and chloromethylstyrene;
(8) vinyl ketones such as methyl vinyl ketone, ethyl vinyl ketone, propyl vinyl ketone and phenyl vinyl ketone;
(9) Olefins such as ethylene, propylene, isobutylene, butadiene and isoprene;
(10) N-vinylpyrrolidone, N-vinylcarbazole, 4-vinylpyridine, acrylonitrile and methacrylonitrile; and
(11) Unsaturated imides such as maleimide, N-acryloylacrylamide, N-acetylmethacrylamide, N-propionylmethacrylamide and N-(p-chlorobenzoyl)methacrylamide.

Further, monomers represented by the following general formula (2) are also preferably used. 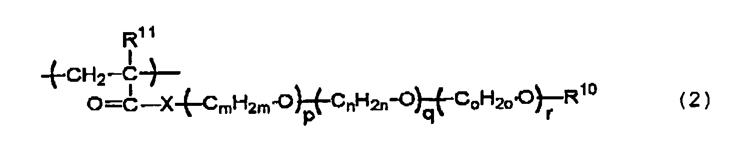 wherein X represents O, S or N-R¹², R¹⁰ to R¹² each independently represents a hydrogen atom or an alkyl group, m, n and o each independently represents an integer of from 2 to 5, CₘH_{2m,} CₙH₂ₙ and CₒH₂ₒ may each have either a straight-chain structure or a branched structure, p, q and r each independently represents an integer of from 0 to 3,000, and p+q+r is 2 or more.

The alkyl group in R¹⁰ to R¹² is preferably an alkyl group having 1 to 12 carbon atoms. Specific examples thereof include methyl, ethyl, n-propyl and isopropyl. p, q and r each represents preferably an integer of from 0 to 500, and more preferably an integer of from 0 to 100.

Examples of the monomers corresponding to repeating units represented by the above-mentioned general formula (2) include but are not limited to the following: 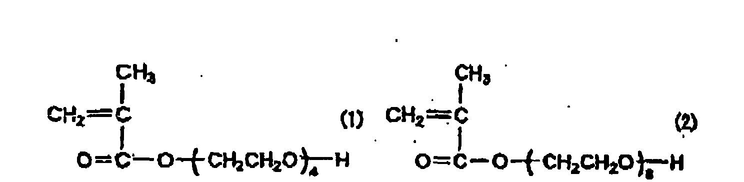 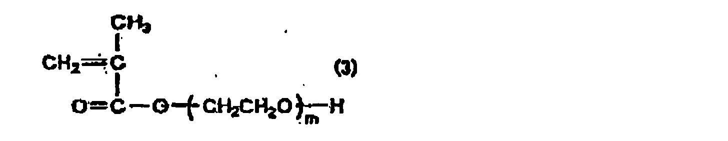 (Average molecular weight of the alkylene oxide: 1000) 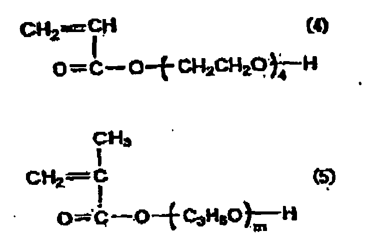 (Average molecular weight of the alkylene oxide: 1000). 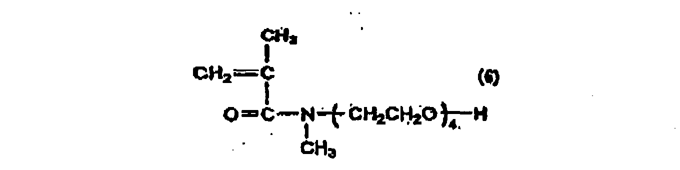 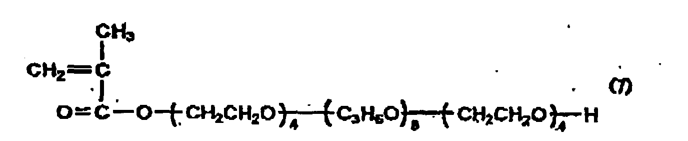 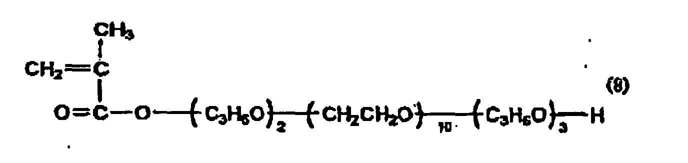 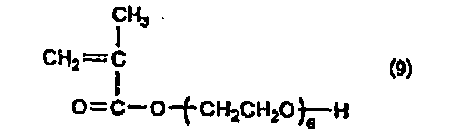 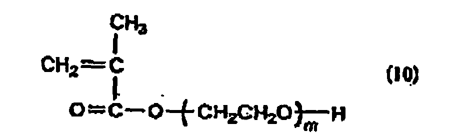 (Average molecular weight of the alkylene oxide: 500) 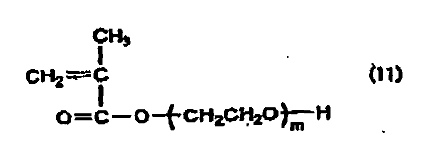 (Average molecular weight of the alkylene oxide: 2000) 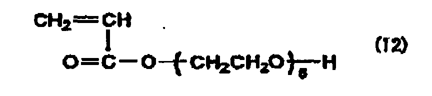 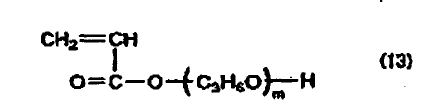 (Average molecular weight of the alkylene oxide: 1500)

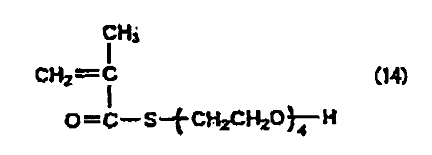

The repeating units represented by the above-mentioned general formula (2) can be produced by reacting commercially available hydroxypoly(oxyalkylene) materials such as materials sold under the trade names of Pluronic (manufactured by Asahi Denka Kogyo K.K.), Adeka Polyether (manufactured by Asahi Denka Kogyo K.K.), Carbowax (manufactured by Glico Products Co.), Triton (manufactured by Rohm and Haas Co.) and P.E.G. (manufactured by Dai-ichi Kogyo Seiyaku Co., Ltd.) with acrylic acid, methacrylic acid, acryloyl chloride, methacryloyl chloride or acrylic anhydride by known methods.

In addition to these materials, poly(oxyalkylene) diacrylates produced by known methods can also be used.

The commercially available monomers include hydroxyl group-terminated polyalkylene glycol mono(meth)acrylates manufactured by Nippon Oil & Fats Co., Ltd. such as Blenmer PE-90, Blenmer PE-200, Blenmer PE-350, Blenmer AE-90, Blenmer AE-200, Blenmer AE-400, Blenmer PP-1000, Blenmer PP-500, Blenmer PP-800, Blenmer AP-150, Blenmer AP-400, Blenmer AP-550, Blenmer AP-800, Blenmer 50PEP-300, Blenmer 7OPEP-350B, Blenmer AEP series, Blenmer 55PET-400, Blenmer 30PET-800, Blenmer 55PET-800, Blenmer AET series, Blenmer 30PPT-800, Blenmer 50PPT-800, Blenmer 70PPT-800, Blenmer APT series, Blenmer 10PPB-500B and Blenmer 10APB-500B. Similarly, the monomers include alkyl-terminated polyalkylene glycol mono(meth)acrylates manufactured by Nippon Oil & Fats Co., Ltd. such as Blenmer PME-100, Blenmer PME-200, Blenmer PME-400, Blenmer PME-1000, Blenmer PME-4000, Blenmer AME-400, Blenmer 50POEP-800B, Blenmer 50AOEP-800B, Blenmer PLE-200, Blenmer ALE-200, Blenmer ALE-800, Blenmer PSE-400, Blenmer PSE-1300, Blenmer ASEP series, Blenmer PKEP series, Blenmer AKEP series, Blenmer ANE-300, Blenmer ANE-1300, Blenmer PNEP series, Blenmer PNPE series, Blenmer 43ANEP-500 and Blenmer 70ANEP-550, and Light-Ester MC, Light-Ester 130MA, Light-Ester 041MA, Light-Acrylate BO-A, Light-Acrylate EC-A, Light-Acrylate MTG-A, Light-Acrylate 130A, Light-Acrylate DPM-A, Light-Acrylate P-200A, Light-Acrylate NP-4EA and Light-Acrylate NP-8EA manufactured by Kyoeisha Chemical Co., Ltd.

In polymer compound (b1-1), it is unnecessary that the minimum constituent units having polymerizable monomer components each having at least one carboxyl group and at least one polymerizable unsaturated group in its molecule are of only one type. A compound obtained by polymerizing two or more types of minimum constituent units having the same acidic groups or different acidic groups can also be used.

As copolymerization methods, there can be used conventional graft copolymerization, block copolymerization and random copolymerization.

### (b1-2 Carboxyl group-containing alkali soluble polymer compounds having as basic skeletons reaction products of carboxyl group-containing diol compounds represented by the following general formula (3), (4) or (5) and diisocyanate compounds represented by the following general formula (8) (hereinafter also referred to as polymer compound (b1-2))

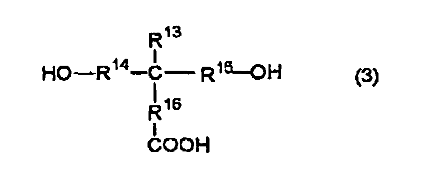

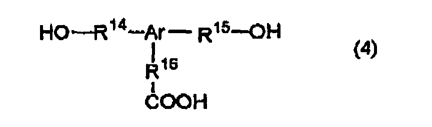

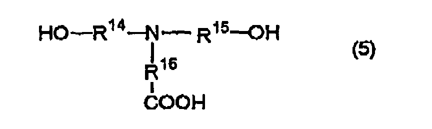

wherein R¹³ represents a hydrogen atom or an alkyl, alkenyl, aralkyl, aryl, alkoxyl or aryloxy group, each of which may have a substituent group (for example, preferably an alkyl group, an aryl group, an alkoxyl group, an ester group, a urethane group, an amido group, a ureido group or a halogeno group), and preferably a hydrogen atom, an alkyl group having 1 to 8 carbon atoms, an alkenyl group having 2 to 8 carbon atoms or an aryl group having 6 to 15 carbon atoms.

R¹⁴, R¹⁵ and R¹⁶, which may be the same or different, each represents a divalent aliphatic or aromatic hydrocarbon which may have a single bond or a substituent group (for example, preferably an alkyl group, an alkenyl group, an aralkyl group, an aryl group, an alkoxyl group or a halogeno group), preferably an alkylene group having 1 to 20 carbon atoms or an arylene group having 6 to 15 carbon atoms, and still more preferably an alkylene group having 1 to 8 carbon atoms.

Further, R¹⁴, R¹⁵ and R¹⁶ may each contain another functional group unreactive to an isocyanate group, for example, an ester group, a urethane group, an amido group, a ureido group or a carbon-carbon unsaturated bond, as needed. Two or three of R¹³, R¹⁴, R¹⁵ and R¹⁶ may form a ring.

Ar represents a trivalent aromatic hydrocarbon which may have a substituent group, and preferably an aromatic group having 6 to 15 carbon atoms.

OCN-R¹⁸-NCO (8)

wherein R¹⁸ represents a divalent aliphatic or aromatic hydrocarbon which may have a substituent group (for example, preferably an alkyl group, an alkenyl group, an aralkyl group, an aryl group, an alkoxyl group or a halogeno group). R¹⁸ may contain another functional group unreactive to an isocyanate group, for example, an ester group, a urethane group, an amido group, a ureido group or a carbon-carbon unsaturated bond, as needed.

Specific examples of the carboxyl group-containing diol compounds represented by the following general formula (3), (4) or (5) include 3, 5-dihydroxybenzoic acid, 2, 2-bis (hydroxymethyl)propionic acid, 2,2-bis (2-hydroxyethyl)propionic acid, 2, 2-bis (3-hydroxypropyl) propionic acid, bis (hydroxymethyl)acetic acid, bis(4-hydroxyphenyl)acetic acid, 4,4-bis(4-hydroxyphenyl)pentanoic acid, tartaric acid and N,N-bis (2-hydroxyethyl)-3-carboxypropionamide.

The carboxyl group-containing alkali-soluble polymer compound of (b1-2) is preferably a reaction product in which a diol represented by the following general formula (6) or (7) is combined. 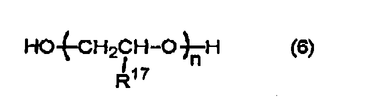 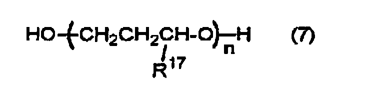 wherein R¹⁷ represents a hydrogen atom or an alkyl group having 1 to 8 carbon atoms, and n represents an integer of 2 or more. The alkyl groups each having 1 to 8 carbon atoms represented by R¹⁷ include methyl, ethyl, isopropyl, n-butyl and isobutyl.

Specific examples of the diols represented by the above-mentioned general formula (6) or (7) are shown below, but the invention should not be construed as being limited thereto.

Specific examples of the diols of formula (6)

HO-(-CH₂CH₂O-) ₃-H

HO-(-CH₂CH₂O-)₄-H

HO-(-CH₂CH₂O-)₅-H

HO-(-CH₂CH₂O-)₆-H

HO-(-CH₂CH₂O-)₇-H

HO-(-CH₂CH₂O-)₈-H

HO-(-CH₂CH₂O-)₁₀-H

HO-(-CH₂CH₂O-)₁₂-H

Polyethylene glycol (average molecular weight: 1000)
Polyethylene glycol (average molecular weight: 2000)
Polyethylene glycol (average molecular weight: 4000)

HO-(-CH₂CH (CH₃) O-)₃-H

HO-(-CH₂CH (CH₃) O-)₄-H

HO-(-CH₂CH (CH₃) O-)₆-H

Polypropylene glycol (average molecular weight: 1000)
Polypropylene glycol (average molecular weight: 2000)
Polypropylene glycol (average molecular weight: 4000)

Specific examples of the diols of formula (7)

HO-(-CH₂CH₂CH₂O-)₃-H

HO-(-CH₂CH₂CH₂O-)₄-H

HO-(-CH₂CH₂CH₂O-)₈-H

HO-(-CH₂CH₂CH (CH₃) O-)₁₂-H

Specific examples of the diisocyanate compounds represented by general formula (8) include aromatic diisocyanate compounds such as 2,4-tolylene diisocyanate, a dimer of 2, 4-tolylenediisocyanate, 2, 6-tolylenediisocyanate, p-xylylene diiscyanate, m-xylylene diiscyanate, 4,4'-diphenylmethane diisocyanate, 1,5-naphthalene diisocyanate and 3,3'-dimehtylbiphenyl-4,4'-diisocyanate; aliphatic diisocyanate compounds such as hexamethylene diisocyanate, trimethylhexamethylene diisocyanate, lysine diisocyanate and dimer acid diisocyanate; alicyclic diisocyanate compounds such as isophorone diisocyanate, 4,4'-methylenebis(cyclohexyl isocyanate) methylcyclohexane-2, 4- (or 2,6-) diisocyanate and 1, 3-(isocyanatemethyl)cyclohexane; and diisocyanate compounds which are reaction compounds of diols and diisocyanates such as an addition product of 1 mole of 1,3-butylene glycol and 2 moles of tolylene diisocyanate.

The molar ratio of the diisocyanate to the diol compound used in synthesis of polymer compound (b1-2) is preferably from 0.8:1 to 1.2:1. When an isocyanate group remains at a polymer terminal, the polymer compound is treated with an alcohol or an amine, thereby being synthesized finally with no isocyanate group remaining.

As component (B1), the above-mentioned polymer compounds (b1-1) and (b1-2) may be used either alone or as a combination of two or more of them.

The content of carboxyl group-containing repeating units contained in component (B1) is 2 mol% or more, preferably from 2 to 70 mol%, and more preferably from 5 to 60 mol%.

The weight average molecular weight of component (B1) is preferably from 3,000 to 300,000, and more preferably from 6,000 to 100,000.

Further, the amount of component (B1) added is preferably from 0.005% to 80% by weight, more preferably from 0.01% to 50% by weight, and still more preferably from 1% to 20% by weight, based on the total solid weight of the image-forming layer.

When the amount of component (B1) added is less than 0. 005% by weight, the effect is insufficient. On the other hand, exceeding 80% by weight results in insufficient drying of a coating film to exert an adverse effect on the performance (for example, sensitivity) of the photosensitive material.

### (B2) Alkali-Soluble Resins

As the available alkali-soluble resin (hereinafter also referred to as component (B2)), there can be used an aqueous alkali-soluble polymer compound having any one of acidic groups of the following (1) to (3) in a main chain and/or side chain structure thereof:
(1) Phenol group (-Ar-OH)
(2) Sulfonamido group (-SO₂NH-R)
(3) Substituted sulfonamide-based acid group (hereinafter referred as an active imido group) (-SO₂NHCOR, -SO₂NHSO₂R, -CONHSO₂R)

In the above-mentioned (1) to (3), Ar represents a divalent aryl connecting group which may have a substituent group, and R represents a hydrocarbon group which may have a substituent group.

Specific examples thereof are shown below, but the invention should not be construed as being limited thereto.

(1) The phenol group-containing alkali-soluble polymer compounds include, for example, novolak resins such as a condensation polymer of phenol and formaldehyde, a condensation polymer of m-cresol and formaldehyde, a condensation polymer of p-cresol and formaldehyde, a condensation polymer of mixed m-/p-cresol and formaldehyde and a condensation polymer of phenol and cresol (which may be p-, m- or mixed m-/p-cresol), and a condensation polymer of pyrogallol and acetone. They further include a polymer compound obtained by polymerizing a monomer having a phenol group in its side chain.

The polymer compounds having phenolic hydroxyl groups in their side chains include a polymer compound obtained by homopolymerizing a polymerizable monomer of a low molecular weight compound having at least one phenolic hydroxyl group and at least one polymerizable unsaturated bond, or by copolymerizing the polymerizable monomer with another polymerizable monomer.

The polymer compounds having phenol groups in their side chains include acrylamides, methacrylamides, acrylates, methacrylates and hydroxystyrenes which have phenol groups in their side chains.

Specifically, preferred examples thereof include N-(2-hydroxyphenyl)acrylamide, N-(3-hydroxyphenyl)acrylamide, N-(4-hydroxyphenyl)acrylamide, N-(2-hydroxyphenyl)-methacrylamide, N-(3-hydroxyphenyl)methacrylamide, N-(4--hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl) ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3--hydroxyphenyl)ethyl methacrylate and 2-(4-hydroxyphenyl)-ethyl methacrylate.

The weight average molecular weight of the above-mentioned phenol group-containing alkali-soluble polymer compound is preferably from 5.0X10² to 2.0X10⁵, and the number average molecular weight thereof is preferably from 2.0X10² to 1.0X10⁵, in respect to image-forming properties.

Further, the phenol group-containing alkali-soluble polymer compounds may be used not only alone but also as a combination of two or more of them. When used as a combination, they may be used in combination with a condensation polymer of a phenol having an alkyl group of 3 to 8 carbon atoms as a substituent group and formaldehyde such as a condensation polymer of t-butylphenol and formaldehyde or a condensation polymer of octylphenol and formaldehyde as described in U.S. Patent 4,123,279.

The weight average molecular weight of this condensation polymer is also preferably from 5.0X10² to 2.0X10⁵, and the number average molecular weight thereof is also preferably from 2.0X10² to 1.0X10⁵.

(2) The sulfonamido group-containing alkali-soluble polymer compounds include, for example, a polymer having a sulfonamido group-containing compound as a main monomer constituent unit, that is to say, a copolymer obtained by copolymerizing a homopolymer or the above-mentioned monomer constituent unit with another polymerizable monomer.

The sulfonamido group-containing polymerizable monomers include a monomer of a low molecular weight compound having at least one sulfonamido group -SO₂-NH- in which at least one hydrogen atom is bonded to a nitrogen atom, and at least one polymerizable unsaturated bond, in one molecule. Above all, a low molecular weight compound is preferred which has an acryloyl group, an allyl group or a vinyloxy group, and a substituted or monosubstituted aminosulfonyl group or a substituted sulfonylimino group.

Examples of the low molecular weight compounds include but are not limited to compounds represented by the following general formulas (a) to (e): 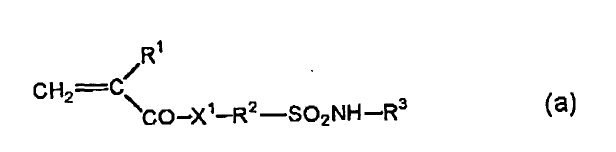 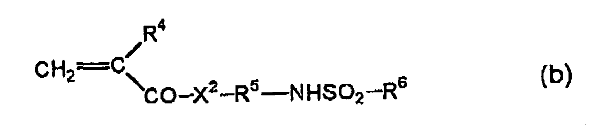 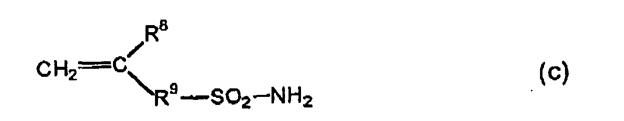 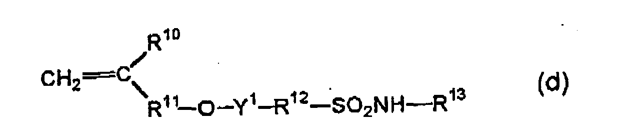 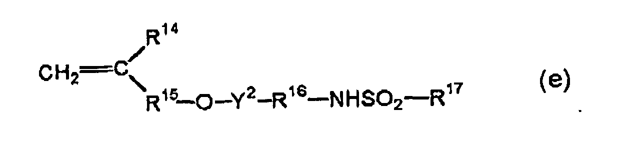 wherein X¹ and X² each independently represents an oxygen atom or NR⁷; R¹ and R⁴ each independently represents a hydrogen atom or CH₃; R², R⁵, R⁹, R¹² and R¹⁶ each independently represents an alkylene group having 1 to 12 carbon atoms, a cycloalkylene group, an arylene group or an aralkylene group, each of which may have a substituent group; R³, R⁷ and R¹³ each independently represents an alkyl group having 1 to 12 carbon atoms, a cycloalkyl group, an aryl group or an aralkyl group, each of which may have a substituent group; R⁶ and R¹⁷ each independently represents an alkyl group having 1 to 12 carbon atoms, a cycloalkyl group, an allyl group or an aralkyl group, each of which may have a substituent group; R⁸, R¹⁰ and R¹⁴ each independently represents a hydrogen atom or CH₃; R¹¹ and R¹⁵ each independently represents an alkylene group having 1 to 12 carbon atoms, a cycloalkylene group, an arylene group or an aralkylene group, each of which may have a single bond or a substituent group; and Y¹ and Y² each independently represents a single bond or CO.

m-Aminosulfonylphenyl methacrylate, N-(p-aminosulfonylphenyl)methacrylamide and N-(p-aminosulfonylphenyl)acrylamide can be suitably used among others.

(3) The active imido group-containing alkali-soluble polymer compounds include, for example, a polymer having an active imido group-containing compound as a main monomer constituent unit.

The polymers having the active imido group-containing compounds as the main monomer constituent units include apolymer compound obtained by homopolymerizing a monomer of a low molecular weight compound having at least one active imido group represented by the following general formula and at least one polymerizable unsaturated bond in one molecule, or by copolymerizing the monomer with another polymerizable monomer.

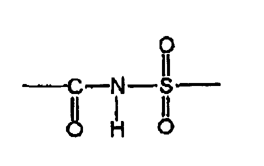

Specifically, preferred examples of such compounds include N-(p-toluenesulfonyl)methacrylamide and N-(p--toluenesulfonyl)acrylamide.

Further, in addition to the above, preferred examples thereof include a polymer compound obtained by polymerizing two or more of the above-mentioned phenol-group containing polymerizable monomer, sulfonamido group-containing polymerizable monomer and active imido group-containing polymerizable monomer, or by further copolymerizing another polymerizable monomer with these two or more polymerizable monomers.

When the sulfonamido group-containing polymerizable monomer (M2) and/or the active imido group-containing polymerizable monomer (M3) is copolymerized with the phenol-group containing polymerizable monomer (M1), the compounding ratio (M1:M2 and/or M3 by weight) is preferably from 50:50 to 5:95, and more preferably from 40:60 to 10:90.

When the alkali-soluble resin is a copolymer composed of a monomer consistent unit having any one selected from the above-mentioned acidic groups (1) to (3) and a monomer consistent unit of another polymerizable monomer, the monomer consistent unit having any one selected from the above-mentioned acidic groups (1) to (3) is contained in the copolymer preferably in an amount of 10 mol% or more, and more preferably in an amount of 20 mol% or more.

When the content of the monomer consistent unit is less than 10 mol%, sufficient alkali solubility is not obtained, resulting in narrow development latitude in some cases.

As methods for synthesizing the above-mentioned copolymer, there can be used graft copolymerization, block copolymerization and random copolymerization which have hitherto been known.

Examples of the other polymerizable monomers each copolymerized with the polymerizable monomer having as a monomer consistent unit a monomer containing any one selected from the above-mentioned acidic groups (1) to (3) include but are not limited to the following (a) to (1):
(a) Aliphatic hydroxyl group-containing acrylates and methacrylates such as 2-hydroxyethyl acrylate and 2-hydroxyethyl methacrylate;
(b) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate and N-dimethylaminoethyl acrylate;
(c) Alkyl methacrylates such as methyl methacrylate, ethyl methacrylate, propyl methacrylate, butyl methacrylate, amyl methacrylate, hexylmethacrylate, cyclohexyl methacrylate, benzyl methacrylate, 2-chloroethyl methacrylate, glycidyl methacrylate and N-dimethylaminoethyl methacrylate;
(d) Acrylamides and methacrylamides such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide;
(e) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(f) Vinyl esters such as vinyl acetate, vinyl chloroacetate, vinyl butyrate and vinyl benzoate;
(g) Styrenes such as styrene, α-methylstyrene, methylstyrene and chloromethylstyrene;
(h) Vinyl ketones such as methyl vinyl ketone, ethyl vinyl ketone, propyl vinyl ketone and phenyl vinyl ketone;
(i) Olefins such as ethylene, propylene, isobutylene, butadiene and isoprene;
(j) N-vinylpyrrolidone, N-vinylcarbazole, 4-vinylpyridine, acrylonitrile and methacrylonitrile;
(k) Unsaturated imides such as maleimide, N--acryloylacrylamide, N-acetylmethacrylamide, N-propionylmethacrylamide and N-(p-chlorobenzoyl)methacrylamide; and
(1) Unsaturated carboxylic acids such as acrylic acid, methacrylic acid, maleic anhydride and itaconic anhydride.
The weight average molecular weight of the above--mentioned alkali-soluble resin is preferably from 2, 000 or more, and the number average molecular weight thereof is preferably 500 or more, in respect to film strength, regardless of whether it is a homopolymer or a copolymer. More preferably, the weight average molecular weight is from 5,000 to 300,000, the number average molecular weight is from 800 to 250, 000, and the degree of dispersion (weight average molecular weight/number average molecular weight) is from 1.1 to 10.

Further, when the alkali-soluble resin is a phenol-formaldehyde resin or a cresol-aldehyde resin, the weight average molecular weight is preferably from 500 to 20, 000, and the number average molecular weight is preferably from 200 to 10,000.

The content of the alkali-soluble resin is preferably from 30% to 99% by weight, more preferably from 40% to 95% by weight, and most preferably from 50% to 90% by weight, based on the total solid weight of the image-forming layer.

When the content is less than 30% by weight, the durability of the image-forming layer is deteriorated in some cases. On the other hand, when it exceeds 99% by weight, sensitivity and durability are deteriorated in some cases.

Further, the alkali-soluble resins may be used either alone or as a combination of two or more of them.

### (C) Compounds Each Allowed to Be Compatible with the Carboxyl Group-Containing Alkali-Soluble Polymer Compound and the Alkali-Soluble Resin to Decrease Solubility of the Polymer Compound and the Resin in Aqueous Alkali Solution, and Decreased in the Solubility-Decreasing Action by Heating

This component (C) means a compound which is good in compatibility with the above-mentioned components (B1) and (B2) by the action of a hydrogen bonding functional group existing in its molecule to be able to form a homogeneous coating solution for the image-forming layer, and which has the function of inhibiting the alkali solubility of components (B1) and (B2) (solubility inhibiting action) by interaction with components (B1) and (B2).

Component (C) can be appropriately selected from compounds which can interact with the above-mentioned alkali-soluble polymer compounds, such as sulfone compounds, ammonium salts, phosphonium salts and amide compounds, taking into account the interaction with the above-mentioned components (B1) and (B2).

The compounding ratio of component (C) to Components (B1) and (B2) (C/(B1+B2) by weight) is generally preferably from 1/99 to 25/75.

The compound represented by general formula (Z), which has been described in the above-mentioned section of (A) Infrared Absorption Dyes, also has the action of component (C). Accordingly, for example, the use of a cyanine dye as represented by general formula (Z) allows the actions of both components (A) and (C) to be exhibited.

### (D) Cyclic Acid Anhydrides

The cyclic acid anhydride may further be used in the image-forming layer. The cyclic acid anhydride has a bond to be conjugated with a carbonyl group of a carboxylic anhydride in its structure, and an increase in stability of the carbonyl group controls the decomposition rate thereof to decompose at a suitable rate with time in storage, thereby generating an acid. Accordingly, deterioration of developing properties with time in storage can be inhibited to stably maintain the developing properties for a long period of time.

The cyclic acid anhydrides include a compound represented by the following general formula (9) or (10):

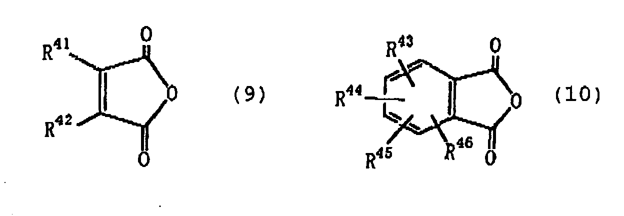

In general formula (9), R⁴¹ and R⁴² each independently represents a hydrogen atom, or an alkyl group having 1 to 12 carbon atoms, an alkenyl group, an alkoxyl group, a cycloalkyl group, an aryl group, a carbonyl group, a carboxyl group or a carboxylate, each of which may have a substituent group. R⁴¹ and R⁴² may combine with each other to form a ring structure.

Preferred examples of R⁴¹ and R⁴² described above include, for example, a hydrogen atom, an unsubstituted alkyl group having 1 to 12 carbon atoms, an aryl group, an alkenyl group and a cycloalkyl group. Specific examples thereof include hydrogen, methyl, ethyl, phenyl, dodecyl, naphthyl, vinyl, allyl and cyclohexyl. These groups may each further have a substituent group.

when R⁴¹ and R⁴² may combine with each other to form a ring structure, the cyclic groups include, for example, a phenylene group, a naphthylene group, a cyclohexene group and a cyclopentene group.

The above-mentioned substituent groups include, for example, a halogen atom, a hydroxyl group, a carbonyl group, a sulfonate, a nitro group and a nitrile group.

In general formula (10), R⁴³, R⁴⁴, R⁴⁵ and R⁴⁶ each independently represents a hydrogen atom, a hydroxyl group, a halogen atom such as chlorine, a nitro group, a nitrile group, or an alkyl group having 1 to 12 carbon atoms, an alkenyl group, an alkoxyl group, a cycloalkyl group, an aryl group, a carbonyl group, a carboxyl group or a carboxylate, each of which may have a substituent group.

Preferred examples of R⁴³, R⁴⁴, R⁴⁵ and R⁴⁶ described above include, for example, a hydrogen atom, a halogen atom, an unsubstituted alkyl group having 1 to 12 carbon atoms, an alkenyl group and an aryl group having 6 to 12 carbon atoms. Specific examples thereof include methyl, vinyl, phenylandallyl. These groups may each further have a substituent group.

The above-mentioned substituent groups include, for example, a halogen atom, a hydroxyl group, a carbonyl group, a sulfonate, a nitro group, a nitrile group and a carboxyl group.

Preferred examples of the cyclic acid anhydrides include phthalic anhydride, 3,4,5,6-tetrahydrophthalic anhydride, hexahydrophthalic anhydride, 3, 6-endooxy-4-tetrahydrophthalic anhydride, tetrachlorophthalic anhydride, 3-hydroxyphthalic anhydride, 3-methylphthalic anhydride, 3-phenylphthalic anhydride, trimellitic anhydride, pyromellitic anhydride, maleic anhydride, phenylmaleic anhydride, dimethylmaleic anhydride, dichloromaleic anhydride, chloromaleic anhydride and succinic anhydride.

The content of the cyclic acid anhydride is preferably from 0.5% to 20% by weight, more preferably from 1% to 15% by weight, and most preferably from 1% to 10% by weight, based on the total solid content of the image-forming layer. When the content is less than 0.5% by weight, the effect of maintaining developing properties becomes insufficient in some cases. On the other hand, exceeding 20% by weight results in failure to form an image in some cases.

The following are components constituting a recording layer of the negative lithographic printing plate.

### (E) Compounds Generating Acids by Heat

When the image formation material is of the negative type, a compound generating an acid in heating (hereinafter referred to as an acid generator) is used in combination. This acid generator is a compound decomposed by heating at 100 °C or more to generate an acid. As the acid generated, a strong acid having a pKa of 2 or less such as sulfonic acid or a hydrochloric acid is preferred.

Preferred examples of the acid generators include onium salts such as an iodonium salt, a sulfonium salt, a phosphonium salt and a diazonium salt. Specifically, they include compounds described in U.S. Patent 4,708,925 and JP-A-7-20629. An iodonium salt, a sulfonium salt and a diazonium salt each having a sulfonic acid ion as a counter ion are preferred among others.

Preferred examples of the diazonium salts include diazonium salt compounds described in U.S. Patent 3,867,147, diazonium compounds described in U.S. Patent 2, 632, 703 and diazo resins described in JP-A-1-102456 and JP-A-102457.

Further, benzylsulfonato compounds described in U.S. Patents 5,135,838 and 5,200,544 and active sulfonates and disulfonyl compounds described in JP-A-2-100054, JP-A-2-100055 and JP-A-8-9444 are also preferred. In addition, haloalkyl-substituted S-triazines described in JP-A-7-271029 are also preferred.

The amount of the acid generator added is preferably from 0.01% to 50% by weight, more preferably from 0.1% to 40% by weight, and most preferably from 0.5% to 30% by weight, based on the total solid weight of the image-forming layer.

### (F) Crosslinking Agents Crosslinked by Acid

When the lithographic printing plate precursor is of the negative type, a compound crosslinked by an acid (hereinafter simply referred to as a crosslinking agent) is used in combination.

The crosslinking agents include the following:
(i) An aromatic compound substituted by an alkoxymethyl group or a hydroxymethyl group;
(ii) A compound having an N-hydroxymethyl group, an N-alkoxymethyl group or an N-acyloxymethyl group; and
(iii) An epoxy compound.

Further, they also include compounds described in JP-A-11-254850 and phenol derivatives.

The amount of the crosslinking agent added is preferably from 5% to 80% by weight, more preferably from 10% to 75% by weight, and most preferably from 20% to 70% by weight, based on the total solid weight of the image-forming layer.

When the above-mentioned phenol derivative is used as the crosslinking agent, the amount of the phenol derivative added is preferably from 5% to 70% by weight and more preferably from 10% to 50% by weight, based on the total solid weight of the image formation material.

Details of the above-mentioned various compounds are described in JP-A-2000-267265.

### Other Components

Various additives can be further added to the image-forming layer of the lithographic printing plate precursor suitable for application of the alkali developer thereto.

For example, in order to improve sensitivity, a known additive such as a phenol, an organic acid or a sulfonyl compound can also be used in combination.

The phenols include bisphenol A, p-nitrophenol, p--ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy--3,5,3',5'-tetramethyltriphenylmethane.

The organic acids include sulfonic acids, sulfinic acids, alkylsulfuric acids, phosphonic acids, phosphates and carboxylic acids described in JP-A-60-88942 and JP-A-2-96755. Specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-2,2-dicarboxylic acid, erucic acid, lauric acid, n-undecanoic acid and ascorbic acid.

The sulfonyl compounds include, for example, bishydroxyphenylsulfone, methylphenylsulfone and diphenyldisulfone.

The amount of the phenol, the organic acid or the sulfonyl compound added is preferably from 0.05% to 20% by weight, more preferably from 0.1% to 15% by weight, and most preferably from 0.1% to 10% by weight, based on the total solid weight of the image-forming layer.

In order to widen the stability of processability to developing conditions, there can be added nonionic surfactants described in JP-A-62-251740 and JP-A-3-208514, amphoteric surfactants described in JP-A-59-121044 and JP-A-4-13149, siloxane compounds as described in EP-950517 and copolymers of fluorine-containing monomers as described in JP-A-11-288093.

The nonionic surfactants include, for example, sorbitan tristearate, sorbitan monopalmitate, sorbitan trioleate, stearic acid monoglyceride and polyoxyethylene nonyl phenyl ether. The amphoteric surfactants include, for example, an alkyldi(aminoethyl)glycine, an alkylpolyaminoethylglycine hydrochloride, a 2-alkyl-N-carboxyethyl-N-hydroxyethylimidazolinium betaine and an N-tetradecyl-N,N-betaine type surfactant (for example, Amogen (trade name) manufactured by Dai-ich Kogyo Seiyaku Co., Ltd.).

As the siloxane compounds, preferred is a block copolymer of a dimethylsiloxane and a polyalkylene oxide, and specific examples thereof include DBE-224, DBE-621, DBE-712, DBP-732, and DBP-534 manufactured by Chisso Corporation, and a polyalkylene oxide-modified silicone such as Tego Glide 100 manufactured by Tego (Germany).

The amount of the nonionic surfactant or the amphoteric surfactant used is preferably from 0.05% to 15% by weight, and more preferably from 0.1% to 5% by weight, based on the total solid weight of the image-forming layer.

A printing out agent for obtaining a visible image immediately after heating by exposure and a dye or a pigment as an image coloring agent can be added to the image-forming layer.

The printing out agents include, for example, a combination of a compound releasing an acid by heating due to exposure to light with an organic dye which can form a salt.

Specific examples thereof include a combination of o--naphthoquinonediazide-4-sulfonic acid halogenides with salt-forming organic dyes described in JP-A-50-36209 and JP-A-53-8128, and a combination of trihalomethyl compounds with salt-forming organic dyes described in JP-A-53-36223, JP-A-54-74728, JP-A-60-3626, JP-A-61-143748, JP-A-61-151644 and JP-A-63-58440.

The trihalomethyl compounds include an oxazole compound and a triazine compound, both of which are excellent in aging stability and give a clear printed-out image.

Besides the salt-forming organic dyes described above, for example, other dyes can also be used as the image coloring agents, and preferred examples thereof include, for example, an oil-soluble dye and a basic dye.

Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (the above are manufactured by Orient Kagaku Kogyo Co., Ltd.), Victoria Pure Blue, Crystal Violet (C.I. 42555), Methyl Violet (C.I. 42535) , Ethyl Violet, Rhodamine B (C.I. 45170B) , Malachite Green (C.I. 42000) and Methylene Blue (C.I. 52015). Dyes described in JP-A-62-293247 are particularly preferred.

The amount of the above-mentioned various dyes added is preferably from 0.01% to 10% by weight, and more preferably from 0.1% to 3% by weight, based on the total solid weight of the image-forming layer.

Further, in order to impart flexibility to a coating film, a plasticizer can be added as needed.

The plasticizers include, for example, butylphthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate and an oligomer and a polymer of acrylic acid or methacrylic acid.

Further, the following various additives can be added as needed.

For example, compounds which are heat decomposable and substantially lower the solubility of the aqueous alkali-soluble polymer compound in their undecomposed state, such as an onium salt, an o-quinonediazide compound, an aromatic sulfone compound and an aromatic sulfonate compound, can be used in combination. The addition of the compounds is preferred in that the ability to prevent the image area from being dissolved in the developing solution is improved.

The onium salts include, for example, a diazonium salt, an ammonium salt, a phosphonium salt, an iodonium salt a sulfonium salt, a selenonium salt and an arsonium salt.

Above all, examples thereof include diazonium salts described in S. I. Schlesinger, *Photogr. Sci. Eng., 18,* 387 (1974), T. S. Baletal., *Plymer, 21,* 423 (1980) and JP-A-5-158230, ammoniumsaltsdescribedin U.S. Patents 4,069,055 and 4,069,056, and JP-A-3-140140, phosphonium salts described in D. C. Necker et al., *Macromolecules, 17,* 2468 (1984), C. S. Wen et al., *The. Proc. Conf. Rad. Curing ASIA,* p. 478, Tokyo, Oct. (1988), U.S. Patents 4,069,055 and 4,069,056, iodonium salts described in J. V. Crivello et al., *Macromolecules, 10*(6), 1307 (1977), *Chem.* *& Eng. News,* p. 31, Nov. 28 (1988), European Patent 104,143, JP-A-2-150848 and JP-A-2-296514,
sulfonium salts described in J. V. Crivello et al., *Polymer* J., *17,* 73 (1985), J. V. Crivello et al., J. Org. Chem., 43, 3055 (1978), W. R. Watt et al., J. *Polymer Sci., Polymer* Chem. *Ed., 22,* 1789 (1984), J. V. Crivello et al., *Polymer Bull., 14,* 279 (1985), J. V. Crivello et al., *Macromolecules, 14*(5), 1141 (1981), J. V. Crivello et al., J. *Polymer Sci., Polymer* Chem. Ed., 17, 2877 (1979), European Patents 370, 693, 233,567, 297, 443 and 297, 442, U.S. Patents 4, 933, 377, 3,902,114, 410,201, 399,049, 4,760,013, 4,734,444, 2,833,827, German Patents 2,904,626, 3,604,580 and 3,604,581,
selenonium salts described in J. V. Crivello et al., *Macromolecules,* 10(6), 1307 (1977) and J. V. Crivello et al., *J. Polymer Sci., Polymerchem. Ed., 17,* 1047 (1979), andarsonium salts described in C. S. Wen et al., The. *Proc. Conf. Rad. Curing* ASIA, p. 478, Tokyo, Oct. (1988).

Of the above, the diazonium salts are preferred, and ones described in JP-A-5-158230 are more preferred among others.

Counter ions for the onium salts include tetrafluoroboric acid, hexafluorophodphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3--chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4--hydroxy-5-benzoylbenzenesulfonic acid and p-toluenesulfonic acid.

Hexafluorophodphoric acid, triisopropylnaphthalenesulfonic acid and an alkyl aromatic sulfonic acid such as 2,5-dimethylbenzenesulfonic acid are preferred among others.

The above-mentioned o-quinonediazide compound is a compound having at least one o-quinonediazide group, and includes a compound increasing alkali solubility by heat decomposition. As such compounds, compounds having various structures can be used.

The o-quinonediazide allows the dissolution preventing ability of the binder to be lost by heat decomposition, and itself is changed to an alkali-soluble substance. The o-quinonediazide facilitates the solubility of the lithographic printing plate precursor by both of the effects.

As the o-quinonediazide compounds described above, there are available, for example, compounds described in J. Coaser, Light-Sensitive Systems, pages 339 to 352 (John Wiley & Sons. Inc.). Above all, sulfonates or sulfonic acid amides of o-quinoneazides allowed to react with various aromatic polyhydroxy compounds or aromatic amino compounds.

Further, benzoquinone-(1,2)-diazidosulfonyl chloride described in JP-A-43-28403, or an ester of benzoquinone--(1,2)-diazidosulfonyl chloride or naphthoquinone-(1,2)--diazido-5-sulfonyl chloride and a phenol-formaldehyde resin described in U.S. Patents 3,046,120 and 3,188,210 is also preferred.

Furthermore, an ester of naphthoquinone-(1,2)-diazido--4-sulfonyl chloride and a phenol-formaldehyde resin or a cresol-formaldehyde resin, or an ester of naphthoquinone--(1,2)-diazido-4-sulfonyl chloride and a pyrogallol-acetone resin is also preferred.

In addition, for example, compounds described in JP-A-47-5303, JP-A-48-63802, JP-A-48-63803, JP-A-48-96575, JP-A-49-38701, JP-A-48-13354, JP-B-41-11222, JP-B-45-9610, JP-B-49-17481, U.S. Patents 2,797,213, 3,454,400, 3,544,323, 3,573,917, 3, 674,495 and 3, 785, 825, British Patents 1, 227, 602, 1,251,345, 1,267,005, 1, 329, 888 and 1,330, 932 and German Patent 854,890 are also useful.

These compounds may be used either alone or as a mixture of several types of them.

The amount of the above-mentioned onium salt, o-quinonediazide compound or aromatic sulfonate added is preferably from 0.1% to 50% by weight, more preferably from 0.5% to 30% by weight, and most preferably from 0.5% to 20% by weight, based on the total solid weight of the image-forming layer.

Besides, in order to enhance the discrimination of images and resistance to scratches on a surface, a polymer having as a polymerization component an acrylate monomer having two or three perfluoroalkyl groups each having 3 to 20 carbon atoms in its molecule as described in JP-A-2000-187318 is preferably used in combination. The amount added is preferably from 0.1% to 10% by weight, and more preferably from 0.5% to 5% by weight, based on the total solid weight of the image-forming layer.

Further, in order to impart the resistance to scratches, a compound decreasing the coefficient of static friction of the surface can also be added. Specific examples thereof include a long-chain alkyl carboxylate as disclosed in U.S. Patent 6,117,913. The amount thereof added is preferably from 0.1% to 10% by weight, and more preferably from 0.5% to 5% by weight, based on the total solid weight of the image-forming layer.

Furthermore, in order to control the solubility of the image-forming layer, various dissolution inhibiting agents may be added. As the dissolution inhibiting agents, disulfone compounds or sulfone compounds as described in JP-A-11-119418 are preferably used. Specifically, 4,4'-bishydroxyphenylsulfone is preferably used. The amount thereof added is preferably from 0.05% to 20% by weight, and more preferably from 0.5% to 10% by weight, based on the total solid weight of the image-forming layer.

Specific examples of the lithographic printing plate precursors to which the plate making method of the invention is applicable also include a lithographic printing plate precursor in which the image-forming layer is a positive heat-sensitive layer having a double-layer structure. That is to say, this positive heat-sensitive layer has a laminated structure, and is characterized in that it comprises a heat-sensitive layer disposed in a position near to a surface (exposure surface) and a lower layer disposed on the side near to a support and containing the alkali-soluble resin and the alkali-soluble polymer compound. Both or one of the heat-sensitive layer and the lower layer can contain (A) the infrared absorption dye, (B1 the carboxyl group-containing alkali-soluble polymer compound, (B2) the alkali-soluble resin, (C) the compound which is allowed to be compatible with the alkali-soluble polymer compound of (B1) and the alkali-soluble resin of (B2) to decrease the solubility of the alkali-soluble polymer compound and the alkali-soluble resin, and which decreases the solubility-decreasing action by heating, and other components, as described above.

As the alkali-soluble resin used in the lower layer, an acrylic resin is preferred from the viewpoint of image formation in development, because the solubility of the lower layer can be kept good to an alkali developer containing an organic compound having a buffering action and a base as main components . Further, this acrylic resin is particularly preferably a resin having a sulfoamido group. Furthermore, as the alkali-soluble polymer compound used in the heat-sensitive layer, a resin having a phenolic hydroxyl group is desirable in that strong hydrogen bonding is induced in an unexposed area and a part of hydrogen bonds are easily released in an exposed area. More preferably, the resin is a novolak resin.

The infrared absorption dye can be added to not only the heat-sensitive layer but also the lower layer. Addition of the infrared absorption dye to the lower layer allows the lower layer to function also as the heat-sensitive layer. When the infrared absorption dye is added to the lower layer, either the same dye as used in the upper heat-sensitive layer or a different dye may be used.

The other additives may be added to the lower layer alone, the heat-sensitive layer alone, or both layers.

The image-forming layer of the lithographic printing plate precursor can be formed by dissolving the above-mentioned respective components in a solvent, and applying the resulting solution onto an appropriate support. The solvents include but are not limited to ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, α-butyrolactone and toluene. The solvents may be used either alone or as a mixture of two or more of them.

When the image-forming layer has the double-layer structure, it is preferred that the solvent whose solubility to the alkali-soluble resin used in the heat-sensitive layer is different from that to the alkali-soluble resin used in the lower layer is selected. That is to say, when a solvent which can dissolve the alkali-soluble resin of the lower layer is used as a coating solvent for the uppermost layer in coating the support with the lower layer, followed by coating with the heat-sensitive layer, the upper layer, in contact with the lower layer, mixing of both layers in a layer interface comes to be not negligible. In the extreme case, the double-layer structure can not be formed, resulting in formation of a single homogeneous layer. It is therefore preferred that the solvent used for coating of the upper heat-sensitive layer is a poor solvent to the alkali-soluble resin contained in the lower layer.

When the support is coated with the image-forming layer, it is preferred that the total solid content of the above-mentioned components contained in the solvent is generally from 1% to 10% by weight.

Further, it is preferred that the dry amount coated (solid content) of the image-forming layer formed on the support after coating and drying is generally from 0.5 to 5.0 g/m². In the case of the double-layer structure, the amount of the heat-sensitive layer is preferably from 0.05 to 1.0 g/m², and the amount of the lower layer is preferably from 0.3 to 3.0 g/m². With a decrease in the amount coated, apparent sensitivity increases, but film characteristics of the image-forming layer deteriorate.

A method for coating the support can be appropriately selected from various known methods. Examples thereof include bar coater coating, rotation coating, spray coating, curtain coating, dip coating, air knife coating, blade coating and roll coating.

In order to improve coating properties, a surfactant, for example, a fluorine surfactant as described in JP-A-62-170950, can be added to the coating solution for the image-forming layer. The amount thereof added is preferably from 0.01% to 1% by weight, and more preferably from 0.05% to 0.5% by weight, based on the total solid weight of the image-forming layer.

### Supports

The supports of the lithographic printing plate precursors include, for example, a pure aluminum plate, an aluminum alloy plate and a plastic film laminated with aluminum or on which aluminum is deposited. A surface of the aluminum plate is preferably subjected to surface treatment such as dressing treatment, immersion treatment in an aqueous solution of sodium silicate, potassium fluozirconate or a phosphate, or anodic oxidization treatment.

Further, an aluminum plate described in U.S. Patent 2, 714, 066 which is subjected to immersion treatment in an aqueous solution of sodium silicate after sand dressing and an aluminum plate described in JP-B-47-5125 which is subjected to immersion treatment in an aqueous solution of an alkali metal silicate after anodic oxidization treatment are also preferred.

The above-mentioned anodic oxidization treatment is conducted by allowing current to flow using the aluminum plate as an anode in an electrolyte in which aqueous solutions or non-aqueous solutions of inorganic acids such as sulfuric acid, phosphoric acid, chromic acid, nitric acid and boric acid, organic acids such as oxalic acid and sulfamic acid, or salts thereof are used either alone or as a combination of two or more of them.

Further, silicate electrodeposition described in U.S. Patent 3,658,662 is also effective.

Supports described in U.S. Patent 4,087,341, JP-B--46-27481 and JP-A-52-30503 which are obtained by applying the above-mentioned anodic oxidization treatment to supports subjected to electrolytic graining are also useful.

An aluminum plate described in U.S. Patent 3,834, 998 which is subjected to chemical etching after sand dressing, and further subjected to anodic oxidization treatment is also useful.

These treatments are applied for various purposes such as prevention of adverse reaction with the image-forming layer formed on the support and improvement in adhesion with the image-forming layer, as well as hydrophilization of the surface of the support.

The lithographic printing plate precursor comprises the support having provided thereon at least the image-forming layer by lamination, and may have an undercoat layer on the support as needed.

Components used in the undercoat layer include various organic compounds, for example, carboxymethyl cellulose; dextrin; gum arabic; amino group-containing phosphonic acids such as 2-aminoethylphosphonic acid; organic phosphonic acids which may have substituent groups, such as phenylphosphonic acid, naphthylphosphonic acid, an alkylphosphonic acid, glycerophosphonic acid, methylenediphosphonic acid and ethylenediphosphonic acid; organic phosphoric acids which may have substituent groups, such as phenylphosphoric acid, naphthylphosphoric acid, an alkylphosphoric acid and glycerolphosphoric acid; organic phosphinic acids which may have substituent groups, such as phenylphosphinic acid, naphthylphosphinic acid, an alkylphosphinic acid and glycerophosphinic acid; amino acids such as glycine and β-alanine; and hydroxyl group-containing amine hydrochlorides such as triethanolamine hydrochloride.

The above-mentioned organic compounds may be used either alone or as a mixture of two or more of them. Further, it is also a preferred embodiment that the above-mentioned diazonium salt is used as the undercoat layer.

In addition, as the undercoat layer, an organic undercoat layer containing at least one organic polymer compound having repeating units represented by the following general formula (11) is also preferred. 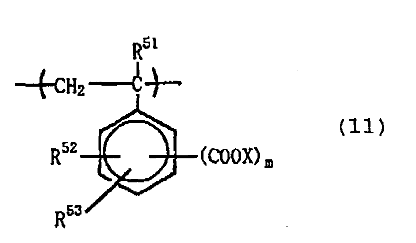 wherein R51 represents a hydrogen atom, a halogen atom or an alkyl group, R⁵² and R⁵³ each independently represents a hydrogen atom, a hydroxyl group, a halogen atom, an alkyl group, a substituted alkyl group, an aryl group, asubstitutedaryl group, - OR⁵⁴, -COOR⁵⁵, -CONHR⁵⁶, -COR⁵⁷ or -CN, and R⁵² and R⁵³ may combine with each other to form a ring structure. R⁵⁴ to R⁵⁷ each independently represents an alkyl group or an aryl group. X represents a hydrogen atom, a metal atom or -NR⁵⁸R⁵⁹R⁶⁰R⁶¹, wherein R⁵⁸ to R⁶¹ each independently represents a hydrogen atom, an alkyl group, a substituted alkyl group, an aryl group, a substituted aryl group, and R⁵⁸ and R⁵⁹ may combine with each other to form a ring structure. M represents an integer of from 1 to 3.

The dry amount of the undercoat layer coated is preferably from 2 to 200 mg/m², and more preferably from 5 to 100 mg/m². When the dry amount coated is less than 2 mg/m², sufficient film properties can not be obtained in some cases. On the other hand, even when the dry amount coated exceeds 200 mg/m², the effect higher than that obtained in an amount coated of 200 mg/m² can not be obtained.

The undercoat layer can be provided by the following method.

That is to say, a solution for the undercoat layer prepared by dissolving the above-mentioned organic compound (s) in water, an organic solvent such as methanol, ethanol or methyl ethyl ketone or a mixed solvent thereof is applied onto the support such as the aluminum plate, followed by drying to provide the undercoat layer, or the support such as the aluminum plate is immersed in a solution for the undercoat layer prepared by dissolving the above-mentioned organic compound(s) in water, an organic solvent such as methanol, ethanol or methyl ethyl ketone or a mixed solvent thereof to allow the solution to be adsorbed thereby, followed by washing with water and drying to provide the undercoat layer.

In the former method, the solution for the undercoat layer containing the above-mentioned organic compound(s) in a concentration of 0.005% to 10% by weight is preferably used.

On the other hand, in the latter method, the concentration of the organic compound(s) contained in the solution for the undercoat layer is preferably form 0.01% to 20% by weight, and more preferably from 0.05% to 5% by weight. The immersing temperature is preferably from 20°C to 90°C, and more preferably from 25°C to 50°C. The immersing time is preferably from 0.1 second to 20 minutes, and more preferably from 2 seconds to 1 minute. The pH of solution for the undercoat layer can be adjusted to the range of 1 to 12 with a basic substance such as ammonia, triethylamine or potassium hydroxide, or an acidic substance such as hydrochloric acid or phosphoric acid.

Further, in order to improve tone reproduction, a yellow dye can also be added.

On the lithographic printing plate precursor prepared as described above, printing can be made with an infrared laser, and besides, recording with an ultraviolet lamp and thermal recording with a thermal head are also possible.

As the infrared laser, a laser radiating an infrared ray having a wavelength of 700 to 1,200 nm is preferred, and a solid or semiconductor laser radiating an infrared having the same wavelength range is more preferred.

### [Examples]

The present invention will be illustrated in greater detail with reference to the following examples, but the invention should not be construed as being limited thereto. All percentages given in the examples are by weight.

### [Preparation of SiO₂-Containing Alkali Developing Solutions]

A compound of formula 1 (0.5 g), 1.0 g of a compound of formula 2 and each of various anionic surfactants (A-1 to A-8) were added to 1 liter of a 4.0% aqueous solution of potassium silicate having a mixing ratio of silicon oxide (SiO₂) to potassium oxide (K₂O) (SiO₂/K₂O) of 1.1, as shown in Table 1 (unit: g/liter). Thus, alkali developers (1) to (12) of the invention were prepared. On the other hand, comparative developing solution (1) having the same composition as described above with the exception that no surfactant was contained therein and comparative developing solution (2) containing a carboxylate type anionic surfactant (A-9 described below) were prepared.

### [Preparation of Nonreducing Sugar-Containing Alkali Developing Solutions]

Potassium carbonate (5 g), 0.5 g of a compound of the following formula S1, 1.0 g of a compound of the following formula S2 and each of various anionic surfactants (A-1 to A-8) were added to 1 liter of a 5.0% aqueous solution of s potassium salt composed of D-sorbit/potassium oxide (K₂O) as a combination of nonreducing sugar and a base, as shown in Table 2 (unit: g/liter) . Thus, alkali developers (13) to (24) of the invention were prepared. On the other hand, comparative developing solution (3) having the same composition as described above with the exception that no surfactant was contained therein and comparative developing solution (4) containing a carboxylate type anionic surfactant (A-9 described below) were prepared.

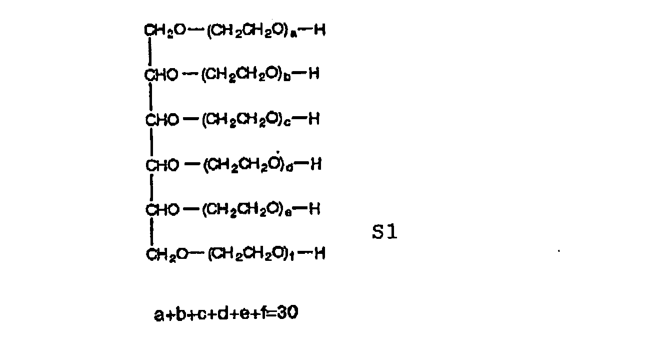

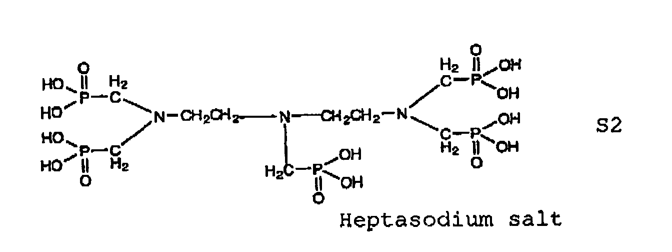

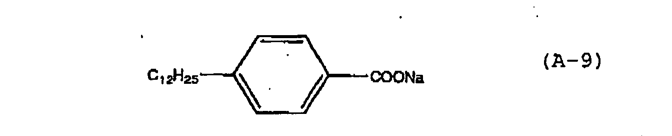

**Table 1**

| SiO₂-Containing Alkali Developing Solution No. | Anionic Surfactant | Concentration (g/l) | Surface Tension (dyne/cm) |
|---|---|---|---|
| 1 | A-1 | 0.5 | 31.0 |
| 2 | A-2 | 0.5 | 30.0 |
| 3 | A-3 | 0.3 | 33.5 |
| 4 | A-3 | 0.5 | 29.0 |
| 5 | A-3 | 1 | 30.5 |
| 6 | A-6 | 0.5 | 31.0 |
| 7 | A-7 | 0.5 | 27.0 |
| 8 | A-4 | 0.5 | 30.5 |
| 9 | A-5 | 0.5 | 34.5 |
| 10 | A-5:A-3= 1:1 | 0.25:0.25 | 34.0 |
| 11 | A-5:A-3= 2:3 | 0.2:0.3 | 34.0 |
| 12 | A-8 | 0.5 | 29.0 |
| Comparative Developing Solution 1 | - | - | 63.0 |
| Comparative Developing Solution 2 | A-9 | 0.5 | 40.0 |

**Table 2**

| Nonreducing Sugar-Containing Alkali Developing Solution No. | Anionic Surfactant | Concentration (g/l) | Surface Tension (dyne/cm) |
|---|---|---|---|
| 13 | A-1 | 0.5 | 32.5 |
| 14 | A-2 | 0.5 | 31.5 |
| 15 | A-3 | 0.3 | 33.5 |
| 16 | A-3 | 0.5 | 30.0 |
| 17 | A-3 | 1 | 31.7 |
| 18 | A-6 | 0.5 | 32.5 |
| 19 | A-7 | 0.5 | 28.0 |
| 20 | A-4 | 0.5 | 30.5 |
| 21 | A-5 | 0.5 | 34.5 |
| 22 | A-5:A-3= 1:1 | 0.25:0.25 | 34.0 |
| 23 | A-5:A-3= 1:1.5 | 0.2:0.3 | 34.0 |
| 24 | A-8 | 0.5 | 29.0 |
| Comparative Developing Solution 3 | - | - | 64.0 |
| Comparative Developing Solution 4 | A-9 | 0.5 | 41.0 |

The surface tension of each developing solution was measured with an automatic dynamic surface tension meter (JET type, manufactured by Kyowa Kaimen Kagaku Co., Ltd.).

### [Synthesis Example 1 of Material for Image-Forming Layer (Component B1: Acrylic Copolymer)]

In a 20-ml three-neck flask equipped with a stirrer, a condenser and a dropping funnel, 6.39 g (0.045 mol) of n-propyl methacrylate, 1.29 g (0.015 mol) of methacrylic acid and 20 g of 1-methoxy-2-propanol were put, and the resulting mixture was stirred while heating it at 65°C on a hot water bath. Then, 0.15 g of a polymerization initiator (v-601, manufactured by Wako Pure Chemical Industries, Ltd.) was added thereto, and the resulting mixture was stirred in a stream of nitrogen for 2 hours while keeping it at 70°C. A mixture of 6.39 g (0.045 mol) of n-propylmethacrylate, 1.29 g (0.015mol) of methacrylic acid, 20 g of 1-methoxy-2-propanol and 0.15 g of V-601 was further added dropwise to this reaction mixture through the dropping funnel for 2 hours. After the termination of dropping, the resulting mixture was further stirred at 90°C for 2 hours. After the termination of the reaction, 40 g of methanol was added to the mixture, followed by cooling. The resulting mixture was poured into 2 liters of water with stirring, and the mixture was stirred for 30 minutes. Then, a precipitate was taken out by filtration and dried to obtain 15 g of a white solid.

The weight average molecular weight (polystyrene standard) of this copolymer was measured by gel permeation chromatography (GPC). As a result, it was 53,000.

### [Synthesis Example 2 of Material for Image-Forming Layer (Component B1: Acrylic Copolymer)]

Using ethyl methacrylate/isobutyi methacrylate/methacrylic acid (mol%: 35/35/30), a copolymer was synthesized by the same operations as with Synthesis Example 1. The weight average molecular weight (polystyrene standard) of the copolymer was measured by GPC. As a result, it was 50,000.

### [Synthesis Example 3 of Material for Image-Forming Layer (Component B1: Polyurethane)]

In a 500-ml three-neck round bottom flask equipped with a cooling condenser and a stirrer, 14.6 g (0.109 mol) of 2,2-bis(hydroxymethyl)propionic acid, 13.3 g (0.0686 mol) of tetraethylene glycol and 2.05 g (0.0228 mol) of 1, 4-butanediol were put, and dissolved in 118 g of N,N-dimethylacetamide. Then, 30.8 g (0.123 mol) of 4,4'-diphenylmethane diisocyanate, 13.8 g (0.0819 mol) of hexamethylene diisocyanate and 0.1 g of di-n-butyltin dilaurate as a catalyst were added thereto, followed by heating at 90°C under stirring for 7 hours.

Then, 100 ml of N,N-dimethylacetamide, 50 ml of methanol and 50 ml of acetic acid were added to this reaction solution, followed by stirring. Thereafter, the resulting solution was poured into 4 liters of water with stirring to precipitate a whitepolymer. This polymer was separatedby filtration, washed with water, and then dried under reduced pressure to obtain 60 g of the polymer.

The weight average molecular weight (polystyrene standard) of the polymer was measured by GPC. As a result, it was 70, 000. Further, the carboxyl group content was measured by titration. As a result, it was 1.43 meq/g.

### [Synthesis Example 4 of Material for Image-Forming Layer (Component B1: Acrylic Copolymer)]

Using 4,4'-diphenylmethane diisocyanate (70 mol%) and hexamethylene diisocyanate (30 mol%) as diisocyanate compounds, and 3, 5-dihydroxybenzoic acid (60 mol%) and 1,6-hexanediol (40 mol%) as diol compounds, a copolymer was synthesized by the same operations as with Synthesis Example 3. The acid content of the resulting copolymer measured by titration was 1.72 meq/g, and the weight average molecular weight (polystyrene standard) thereof was 80,000.

### [Synthesis Example 5 of Material for Image-Forming Layer (Component B2)]

In a 500-ml three-neck round bottom flask equipped with a stirrer, a condenser and a dropping funnel, 31.0 g (0.36mo1) of methacrylic acid, 39.1 g (0.36 mol) of ethyl chloroformate and 200 ml of acetonitrile were put, and the resulting mixture was stirred while cooling it on an ice water bath. Then, 36.4 g (0.36 mol) of triethylamine was added dropwise to this mixture through the dropping funnel for about 1 hour. After the termination of dropping, the ice water bath was removed, and the mixture was stirred at room temperature for 30 minutes. To this reaction mixture, 51.7 g (0.30 mol) of p-aminobenzenesulfonamide was added, and the resulting mixture was stirred for 1 hour while heating it at 70°C on an oil bath. After the termination of the reaction, the resulting mixture was poured into 1 liter of water with stirring, and the mixture was stirred for 30 minutes. This mixture was filtered to take out a precipitate, and the precipitate was slurried with 500 ml of water. Then, the slurry was filtered, and the resulting solid was dried to obtain a white solid of N-(p-aminosulfonylphenyl)methacrylamide (yield: 46.9 g).

Then, 4.61 g (0.0192 mol) of N-(p-aminosulfonylphenyl)-methacrylamide, 2.94 g (0.0258 mol) of ethyl methacrylate, 0.80 g (0.015 mol) of acrylonitrile and 20 gofN,N-dimethylacetamide were put in a 20-ml three-neck flask equipped with a stirrer, a condenser and a dropping funnel, and the resulting mixture was stirred while heating it at 65°C on a hot waterbath. Then, 0.15 g of a polymerization initiator (V-601, manufactured by Wako Pure Chemical Industries, Ltd.) was added thereto, and the resulting mixture was stirred in a stream of nitrogen for 2 hours while keeping it at 65°C. A mixture of 4.61 g of N-(p-aminosulfonylphenyl)methacrylamide, 2.94 g of ethyl methacrylate, 0.80 g of acrylonitrile, N,N-dimethylacetamide and 0.15 g of V-601 was further added dropwise to this reaction mixture through the dropping funnel for 2 hours. After the termination of dropping, the resulting mixture was further stirred at 65°C for 2 hours. After the termination of the reaction, 40 g of methanol was added to the mixture, followed by cooling. The resulting mixture was poured into 2 liters of waterwith stirring, and the mixture was stirred for 30 minutes. Then, a precipitate was taken out by filtration and dried to obtain 15 g of a white solid. The weight average molecular weight (polystyrene standard) of this specific copolymer was measured by gel permeation chromatography. As a result, it was 53,000.

### [Preparation of Lithographic Printing Plate Precursor]

A 0.3-mm thick aluminum plate (material 1050) was washed with trichloroethylene to remove grease. Then, a surface thereof was sand dressed using a nylon brush and an aqueous suspension of 4 00-mesh pumice, and thoroughly washed with water.

After washing, the aluminum plate was immersed in a 25% aqueous sodiumhydroxide solution at 45°C for 9 seconds to conduct etching. After washing with water, the aluminum plate was further immersed in a 20% aqueous nitric acid solution for 20 seconds, and washed with water again. The etched amount of the sand-dressed surface at this time was about 3 g/m².

then, the aluminum plate was subjected to anodization c oxidation using 7% sulfuric acid as an electrolyte and a direct current having a current density of 15 A/dm² to form an anodized film of 3 g/m², followed by washing with water and drying.

The resulting plate was treated with a 2.5% aqueous solution of sodium silicate at 30°C for 10 seconds. After washing with water and drying, the plate was coated with the following coating solution for an undercoat layer, and dried at 80°C for 15 seconds to obtain a support. The dry amount of the undercoat layer coated after drying was 15 mg/m².

| (Coating Solution for Undercoat Layer) | |
|---|---|
| The following copolymer P (molecular weight: 28,000) | 0.3 g |
| Methanol | 100 g |
| Water | 1 g |

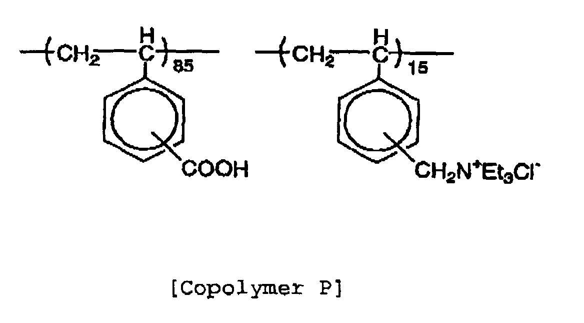

The following coating solution for an image-forming layer is applied onto the resulting support, and dried at 150°C for 30 seconds so as to give a dry amount coated of 1.8 g/m², thus obtaining a positive lithographic printing plate precursor.

| (Coating Solution for Image-Forming Layer) | |
|---|---|
| Copolymer of Synthesis Example 2 Described Above [Component (B1)] | 0.050 g |
| Copolymer of Synthesis Example 4 Described Above [Component (B1)] | 0.050 g |
| Copolymer of Synthesis Example 5 Described Above [Component (B2)] | 0.4 g |
| m-, p-Cresol Novolak [Component (B2)] (m/p ratio: 6/4, weight average molecular weight: 8,000, containing 0.5% of unreacted cresol) | 0.6 g |
| Cyanine Dye A [Component (A+C)] | 0.1 g |
| Phthalic Anhydride [Component (D)] | 0.05 g |
| p-Toluenesulfonic Acid | 0.002 g |
| Ethyl Violet (counter ion: 6-hydroxy-β-naphthalenesulfonic acid) | 0.02 g |
| Esterified Product of Naphthoquinone-1,2-diazide-5-sulfonyl Chloride and pyrogallol-Acetone Resin | 0.01 g |
| Fluorine Surfactant (trade name: Megafac F-177, manufactured by Dainippon Ink & Chemicals, Inc.) | 0.05 g |
| Methyl Ethyl Ketone | 8 g |
| 1-Methoxy-2-propanol | 4 g |

### Examples 1 to 24 and Comparative Examples 1 to 4

The lithographic printing plate precursor obtained above was exposed at a main scanning rate of 5 m/second with a semiconductor laser having an output of 500 mW, a wavelength of 830 nm and a beam diameter of 17 µm (l/e²) , and maintained at 25°C.

This exposed lithographic printing plate precursor was processed with an automatic processor, PS900NP (manufactured by Fuji Photo Film Co., Ltd.), filled with the above-mentioned alkali developer, at a developing temperature of 30°C for 12 seconds. In Examples 1 to 24, alkali developers (1) to (24) were used as shown in Tables 3 to 6, and in Comparative Examples 1 to 4, comparative alkali developers (1) to (4) were used as shown in Tables 3 to 6. The precursor was processed 50 to 3000 m² without replenishment of a replenisher. After the termination of processing, the precursor was washed with water, and then processed with a gum (GU-7 (1:1) manufactured by Fuji Photo Film Co., Ltd.) to obtain a lithographic printing plate in which plate making was completed.

For the lithographic printing plates thus obtained and processed developing solutions, the following items (the developing properties of an non-image area, the film decrease of an image area and the state of a gum-coated surface, scum adhesion and insoluble matter in the developing solution) were evaluated. Results thereof are collectively shown in Tables 3 to 6.

Printing was made under the following conditions:
Printer: KOR-D manufactured by Heidelberg;
Ink: GEOS (N) Black manufactured by Dainippon Ink & Chemicals, Inc.; and
Damping solution: 1% by volume of EU-3 manufactured by Fuji Photo Film Co., Ltd.

### <Evaluation of Developing Properties of Non-Image Area>

The presence or absence of a residual film on a non-image area and the presence or absence of a blot on printed matter were observed just after the start of development and at the time when 50 m², 100 m², 200 m², 300 m², 400 m², 500 m², 1000 m², 2000 m² and 3000 m², respectively, were processed, and the developing properties of the non-image area of the lithographic printing plate obtained as described above were functionally evaluated according to the following criteria. Results thereof are shown in Tables 3 to 6.

### Criteria

Good: The plate was sufficiently developed. No residual image-forming layer was observed on the non-image area. No blot was observed on the printed matter.
Fair: The image-forming layer somewhat remained on the non-image area. No blot was observed on the printed matter.
Poor: Poor development was observed, and the image-forming layer remained on the non-image area. A blot was generated on the printed matter.

### <Evaluation of Film Decrease of Image Area and State of Gum-Coated Surface>

A defect of an image-area and the state of a gum-coated surface of the lithographic printing plate obtained as described above were visually observed just after the start of development and at the time when 50 m², 100 m², 200 m², 300 m², 400 m², 500 m², 1000 m², 2000 m² and 3000 m², respectively, were processed, and functionally evaluated according to the following criteria:

### Criteria

Good: No defect was observed on the image area. No blank area of the image area was also observed on the printed matter. The state of a gum-coated surface was homogeneous and not uneven.
Fair: The density of the image area somewhat decreased, and a defect was partly observed. No blank area of the image area was observed on the printed matter. The state of a gum-coated surface was somewhat uneven.
Poor: The density of the image area substantially decreased, and a defect was observed on the image area. A blank area of the image area was generated on the printed matter. The state of a gum-coated surface was substantially deteriorated.

### <Evaluation of Scum Adhesion>

The number of scum materials adhered onto the lithographic printing plate obtained as described above was counted just after the start of development and at the time when 50 m², 100 m², 200 m², 300 m², 400 m², 500 m², 1000 m², 2000 m² and 3000 m², respectively, were processed.

### <Evaluation of Insoluble Matter in Developing Solution>

A developing solution which processed 1 m², 5 m², 10 m², 15 m² and 20 m², respectively, of the lithographic printing plate precursor, per liter of developing solution, was put in an airtight container, and stored in a thermostat of 35°C for 1 month. The state of occurrence of insoluble matter at this time was observed, and evaluated according to the following criteria:
Good: No insoluble matter.
Fair: Some insoluble matter was observed, but dissolved on shaking to disappear.
Poor: The insoluble matter remained even on shaking.

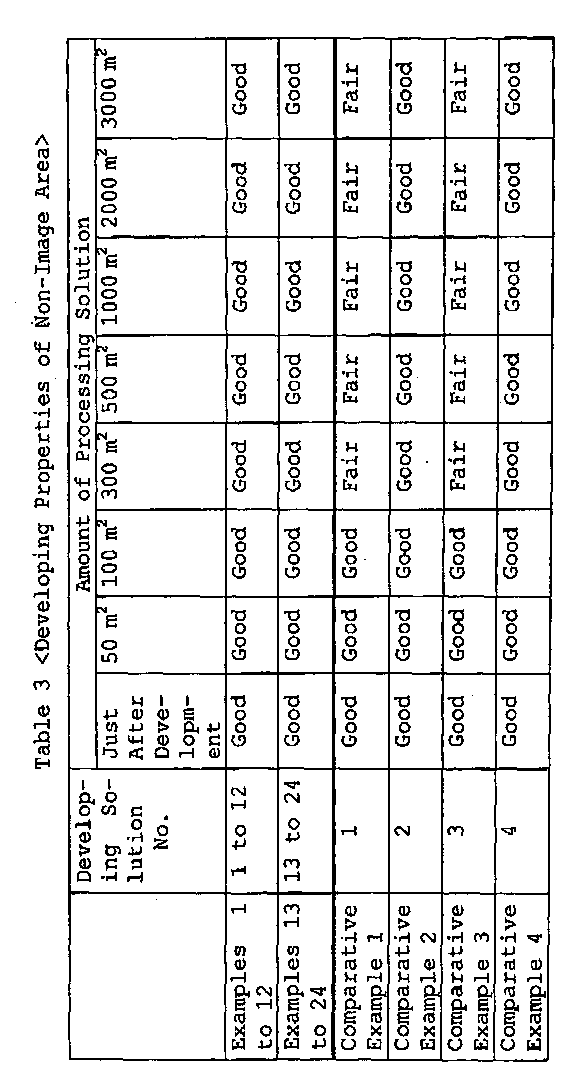

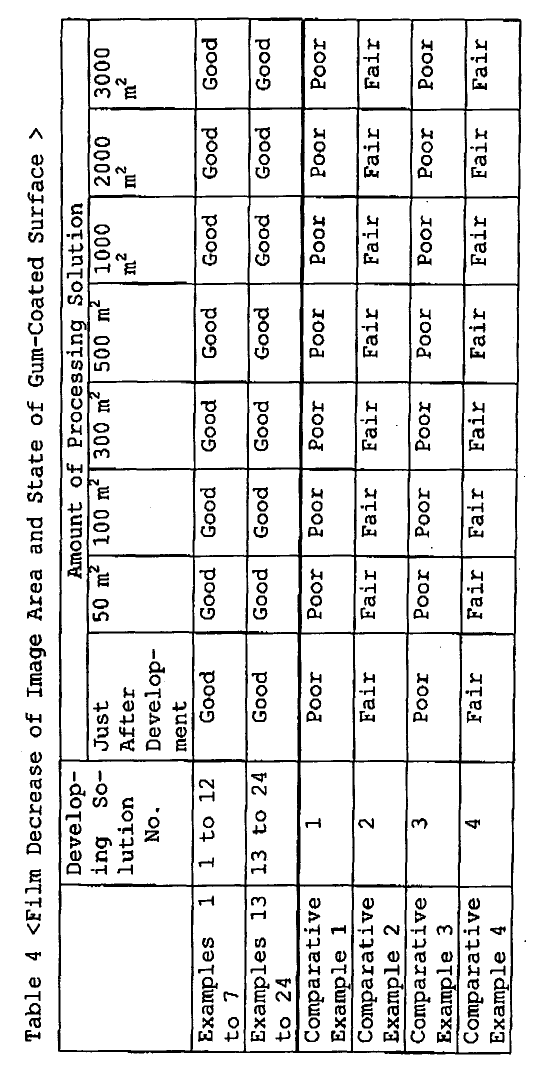

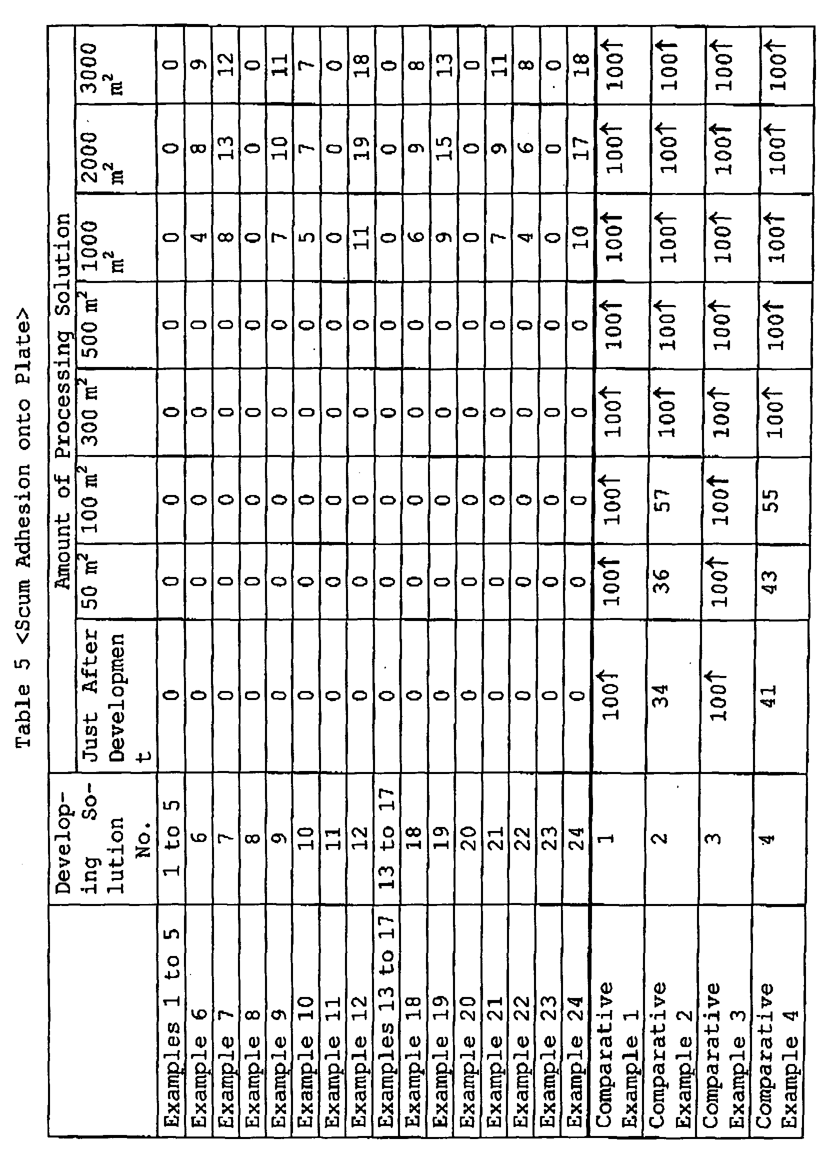

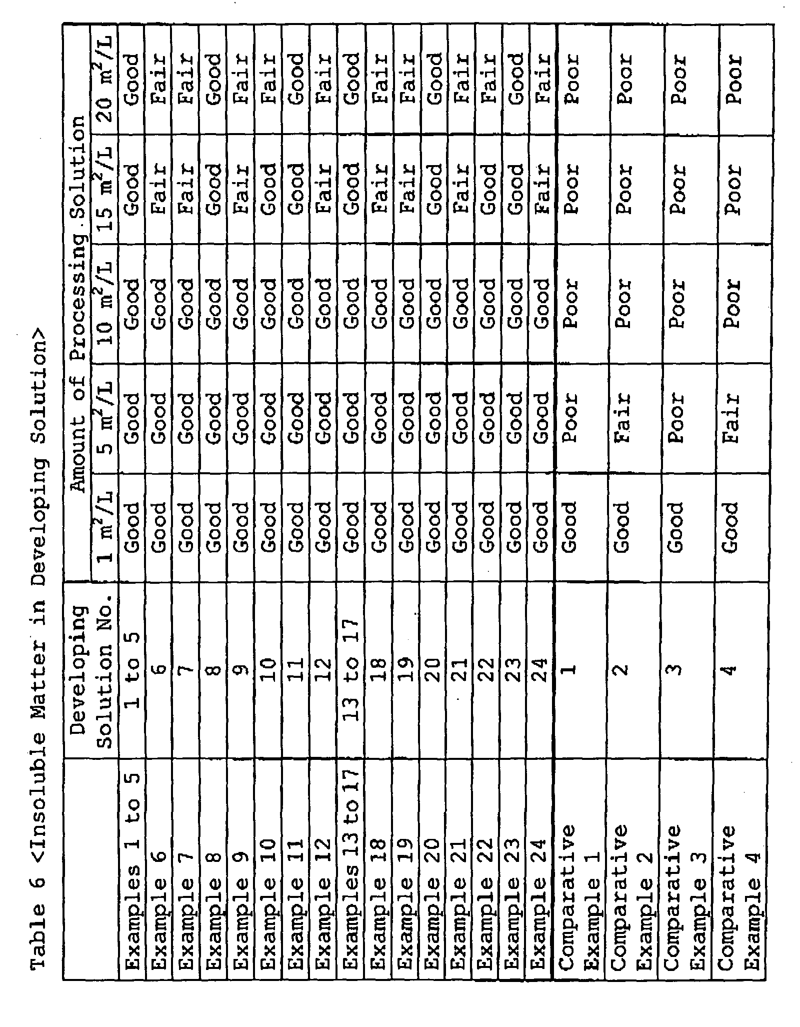

According to the method of the invention for producing the lithographic printing plate, the insoluble matter caused by the components of the image-forming layer can be well dispersed in the plate making process to inhibit the generation of processing scum, while maintaining good developing properties. Further, the plate having no gum repellency thereon and improved in the state of the cum-coated surface can be provided. Then, the lithographic printing plate precursor can be developed stably for a long period of time, and the highly sharp and clear image can be formed.

The entire disclosure of each and every foreign patent application from which the benefit of foreign priority has been claimed in the present application is incorporated herein by reference, as if fully set forth.

## Claims

1. A method for preparing a lithographic printing plate, comprising:
exposing a photosensitive lithographic printing plate precursor having an image-forming layer containing an infrared absorption dye; and
developing the exposed photosensitive lithographic printing plate precursor with an alkali developer, in which the alkali developer includes an anionic surfactant containing a sulfonate group.

2. The method according to claim 1, wherein the anionic surfactant is an anionic surfactant represented by the formula: 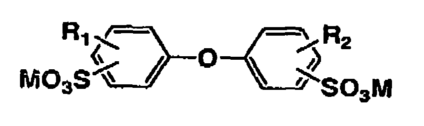 wherein R₁ and R₂ are each independently represents a hydrogen atom or an alkyl group which may be branched, and M represents a univalent alkali metal.

3. The method according to claim 1, wherein the alkali developer comprises: at least one of an alkali silicate and a nonreducing sugar; and a base.

4. The method according to claim 1, wherein the alkali developer has a pH of 12.5 to 14.0.

5. The method according to claim 1, wherein the alkali developer contains silicone oxide and an alkali oxide: M₂O, in which M represents an alkali metal or an ammonium group.

6. The method according to claim 5, wherein the mixing ratio of the silicon oxide to the alkali oxide: M₂O is 0.5 to 3.0.

7. The method according to claim 1, wherein the infrared absorption dye includes at least one of a cyanine dye, a squalilium dye, a pyrylium salt and a nickel thiolate complex.

8. The method according to claim 1, wherein the infrared absorption dye includes a compound represented by the formula (Z): 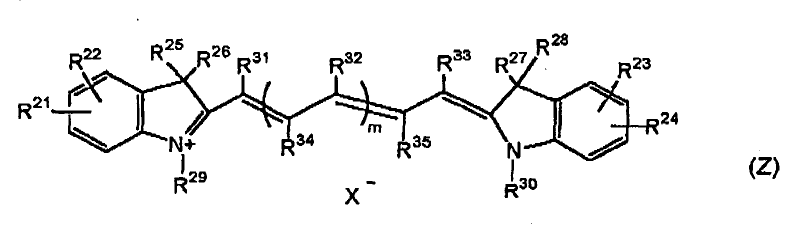 wherein R²¹ to R²⁴ each independently represents a hydrogen atom, or an alkyl group having 1 to 12 carbon atoms, an alkenyl group, an alkoxyl group, a cycloalkyl group or an aryl group, each of which may have a substituent group, and R²¹ and R²², and R²³ and R²⁴ may combine with each other to form a ring structure; R²⁵ to R³⁰ each independently represents an alkyl group having 1 to 12 carbon atoms which may have a substituent group; R³¹ to R³³ each independently represents a hydrogen atom, a halogen atom or an alkyl group having 1 to 8 carbon atoms which may have a substituent group, R³² may combine with R³¹ or R³³ to form a ring structure, and, when m is more than 2, a plurality of R³²' s may combine with each other to form a ring structure; m represents an integer of from 1 to 8; R³⁴ and R³⁵ each independently represents a hydrogen atom, a halogen atom or an alkyl group having 1 to 8 carbon atoms which may have a substituent group, R³⁴ may combine with R³⁵ to form a ring structure, and, when m is more than 2, a plurality of R³⁴'s may combine with each other to form a ring structure; X⁻ represents an anion.

9. The method according to claim 1, wherein the image-forming layer contains the infrared absorption dye in an amount of 0.01 to 50 % by weight based on the total solid weight of the image-forming layer.
